(19) Europäisches Patentamt
European Patent Office
Office européen des brevets

(11) **EP 4 668 119 A1**

(12) **EUROPEAN PATENT APPLICATION**
published in accordance with Art. 153(4) EPC

(43) Date of publication:
**24.12.2025 Bulletin 2025/52**

(21) Application number: 23922699.6

(22) Date of filing: **16.02.2023**

(51) International Patent Classification (IPC):
*G06F 11/22* (2006.01)   *G01R 31/3187* (2006.01)

(52) Cooperative Patent Classification (CPC):
**G01R 31/3187; G06F 11/22**

(86) International application number:
**PCT/JP2023/005354**

(87) International publication number:
**WO 2024/171362 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Astemo, Ltd.**
**Chiyoda-ku,**
**Tokyo 1000004 (JP)**

(72) Inventor: **ARAFUNE Takuya**
**Hitachinaka-shi, Ibaraki 312-8503 (JP)**

(74) Representative: **Strehl & Partner mbB**
**Maximilianstrasse 54**
**80538 München (DE)**

(54) **SEMICONDUCTOR CURRENT COLLECTOR CIRCUIT AND ELECTRONIC CONTROL DEVICE**

(57)    A semiconductor integrated circuit includes: a power supply terminal to which power is supplied from an external power supply; a circuit unit including a plurality of circuits, the plurality of circuits being configured to operate at a predetermined activation ratio, with power supplied from the power supply terminal; a current acquisition unit configured to acquire, from the power supply terminal, a consumption current of the power consumed in the circuit unit; a timer configured to measure an accumulated operation time in which a time during which the circuit unit operates is accumulated; and a symptom diagnosis circuit configured to diagnose a failure symptom in the circuit unit, based on time-series data of the consumption current and the accumulated operation time, acquired on a time-series basis in a diagnosis mode in which the circuit unit operates at an activation ratio higher than a maximum activation ratio of the circuit unit operating normally.

FIG. 2

## Description

Technical Field

The present invention relates to a semiconductor integrated circuit and an electronic control unit.

Background Art

There is required guarantee of more strict reliability than the reliability of a consumer product, for a semiconductor integrated circuit, which is one of semiconductor components for a vehicle. For this reason, each semiconductor supplier performs reliability guarantee for vehicles, and then performs mass production of semiconductor integrated circuits for vehicles. As an example, reliability design for semiconductor integrated circuits is performed, in order to satisfy a quality requirement enabling use for 10 years or traveling up to 200,000 kilometers, if it is for vehicles. The reliability design for the semiconductor integrated circuits includes ideas unique to vehicle manufacturers, and in the design, an operation time of the semiconductor integrated circuit per day is assumed to be about several hours.

In the vehicle industry, active development is underway for autonomous driving technology and advanced driver assistance technology. When the autonomous driving level 4 or higher is put into practical use, it is expected to be unnecessary for a driver to operate a vehicle, and it is expected that driving and all other operations will be performed by a system mounted in the vehicle. In addition, besides the technological development, it is considered that car sharing will be further applied in the future in terms of services. In this case, it is considered that in the future, there will also be a widespread use mode in which a single vehicle is shared among a plurality of users by effectively utilizing an idle time of the vehicle.

In PTL 1, description is made that "In a case where vehicle information is received, this is identified and a check is made as to whether there is a diagnosis result of presence of failure, and in a case where failure is present, various types of data are acquired to estimate a portion at which the failure occurs, and a service procedure is determined, thereby enabling advance arrangement of a corresponding component and smooth operation of a work plan. In addition, in a case where there is no failure, all information of a vehicle is acquired, a deterioration state of a component or a system is calculated, a deterioration characteristic or a life is estimated, and a service required timing is calculated".

Citation List

Patent Literature

PTL 1: JP 2002-322939 A

Summary of Invention

Technical Problem

As described above, the current idea for reliability for a semiconductor integrated circuit for a vehicle includes an assumption that an operation time per day is several hours. This is because a human operates the vehicle as a driver. In the future, in a case where car sharing or full autonomous driving is put into practical use, particularly in a limiting case where automated delivery or the like is assumed, it is assumed that the operation time of the vehicle approaches 24 hours per day. In such a case, it is conceivable that the life of the semiconductor integrated circuit, that is, a failure occurrence timing becomes relatively much earlier than the currently assumed timing, and may be about one year to two years in a shortest estimate.

As described above, for the current semiconductor integrated circuit for a vehicle, reliability design is made that is reliable enough to withstand use in which 10 years of use as a vehicle is assumed or in which causing the vehicle to travel up to 200,000 kilometers is assumed. However, performing reliability design in response to 24-hour operation as described above is not realistic in terms of feasibility and cost. On the other hand, functions performed by the semiconductor integrated circuit, for a vehicle, including a microcomputer in autonomous driving or the like are increasing, and malfunction caused by failure of the semiconductor integrated circuit can be fatal. Therefore, it is desirable to be able to grasp a symptom of failure of the semiconductor integrated circuit before the failure occurs.

Further, it is known that failure due to wear is dominant over failure due to an accidental factor when the life reaches immediately before a life expiration timing of the semiconductor integrated circuit. Since the failure due to wear affects the use environment of the semiconductor integrated circuit, there is a potential for failure occurring in any circuit on the semiconductor integrated circuit. For this reason, in symptom diagnosis for diagnosing a symptom of failure of the semiconductor integrated circuit before the wear failure, the comprehensiveness of performing the symptom diagnosis on any circuit on the semiconductor integrated circuit is important. In consideration of the above, in order for a user to perform a desired response before malfunction occurs in a function of the semiconductor integrated circuit, it is important to provide a method of comprehensively diagnosing a symptom in the semiconductor integrated circuit before failure occurs.

The invention has been made in view of such circumstances, and an object of the invention is to diagnose a symptom before failure of a semiconductor integrated circuit.

Solution to Problem

A semiconductor integrated circuit according to the invention includes: a power supply terminal to which power is supplied from an external power supply; a circuit unit including a plurality of circuits, the plurality of circuits being configured to operate at a predetermined activation ratio, with power supplied from the power supply terminal; a current acquisition unit configured to acquire, from the power supply terminal, a consumption current of the power consumed in the circuit unit; a timer configured to measure an accumulated operation time in which a time during which the circuit unit operates is accumulated; and a symptom diagnosis circuit configured to diagnose a failure symptom in the circuit unit, based on time-series data of the consumption current and the accumulated operation time, acquired on a time-series basis in a diagnosis mode in which the circuit unit operates at an activation ratio higher than a maximum activation ratio of the circuit unit operating normally.

Advantageous Effects of Invention

According to the invention, it is possible to diagnose a symptom before failure of a semiconductor integrated circuit.

Brief Description of Drawings

[FIG. 1] FIG. 1 is a block diagram illustrating an internal configuration example of an ECU, according to a first embodiment of the invention, on which a semiconductor integrated circuit according to the first embodiment of the invention is mounted.

[FIG. 2] FIG. 2 is a block diagram illustrating an internal configuration example of the semiconductor integrated circuit according to the first embodiment of the invention.

[FIG. 3] FIG. 3 is a flowchart illustrating an example of processing in which symptom diagnosis on the semiconductor integrated circuit according to the first embodiment of the invention is performed at the time of activation of the semiconductor integrated circuit.

[FIG. 4] FIG. 4 is a flowchart illustrating an example of processing in which a symptom diagnosis unit of the semiconductor integrated circuit according to the first embodiment of the invention performs the symptom diagnosis.

[FIG. 5] FIG. 5 is a graph illustrating how a power supply current changes with respect to an accumulated operation time according to the first embodiment of the invention.

[FIG. 6] FIG. 6 is a table illustrating contents of time-series data stored in a memory according to the first embodiment of the invention.

[FIG. 7] FIG. 7 is a diagram illustrating examples in each of which a symptom diagnosis circuit according to the first embodiment of the invention sets a symptom diagnosis threshold.

[FIG. 8] FIG. 8 is a diagram illustrating an example in which the symptom diagnosis circuit according to the first embodiment of the invention performs symptom diagnosis on the semiconductor integrated circuit on the basis of a relationship between two points.

[FIG. 9] FIG. 9 is a block diagram illustrating a hardware configuration example of a computer according to the first embodiment of the invention.

[FIG. 10] FIG. 10 is a block diagram illustrating an internal configuration example of a semiconductor integrated circuit according to a second embodiment of the invention.

[FIG. 11] FIG. 11 is a flowchart illustrating an example of a shipment test of the semiconductor integrated circuit according to the second embodiment of the invention.

[FIG. 12] FIG. 12 is a block diagram illustrating a configuration example of a semiconductor integrated circuit according to a third embodiment of the invention.

[FIG. 13] FIG. 13 is a flowchart illustrating an example of processing in which a semiconductor integrated circuit according to a fourth embodiment of the invention changes traveling control after symptom diagnosis.

[FIG. 14] FIG. 14 is a flowchart illustrating an example of processing for identifying a main function circuit having a symptom after a symptom diagnosis circuit according to the fourth embodiment of the invention performs symptom diagnosis.

[FIG. 15] FIG. 15 is a flowchart illustrating an example of processing performed by a symptom diagnosis unit of a semiconductor integrated circuit according to a fifth embodiment of the invention.

[FIG. 16] FIG. 16 is a block diagram illustrating a configuration example of a semiconductor integrated circuit according to a sixth embodiment of the invention.

[FIG. 17] FIG. 17 is a flowchart illustrating an example of processing in which a symptom diagnosis unit of the semiconductor integrated circuit according to the sixth embodiment of the invention performs symptom diagnosis and individual diagnosis.

[FIG. 18] FIG. 18 is a block diagram illustrating an internal configuration example of an ECU, according to a seventh embodiment of the invention, on which semiconductor integrated circuits according to the seventh embodiment of the invention are mounted.

[FIG. 19] FIG. 19 is a flowchart illustrating an example of symptom diagnosis performed in the ECU according to the seventh embodiment of the invention.

[FIG. 20] FIG. 20 is a block diagram illustrating an internal configuration example of an ECU, according to an eighth embodiment of the invention, on which semiconductor integrated circuits according to the eighth embodiment of the invention are mounted.

Description of Embodiments

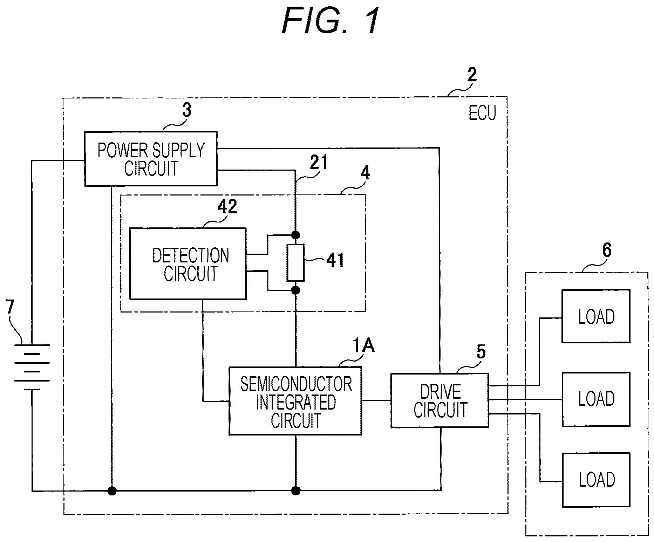

Embodiments of the invention are hereinafter described with reference to the accompanying drawings. Constituent elements having substantially the same function or configuration are denoted by the same reference sign, whereby repetitive description thereof will be omitted herein and in the drawings. In addition, the configuration diagrams and the timing charts in FIGS. 1 to 19 are examples of the embodiments according to the invention, and are not restrictive of the claims. The configurations and operations of semiconductor integrated circuits according to the following embodiments are merely examples, and are not restrictive of the invention, as claimed. The invention can be applied to, for example, a calculation device, for vehicle control, with which an in-vehicle electronic control unit (ECU) for an advanced driver assistance system (ADAS) or autonomous driving (AD) can communicate.

[First Embodiment]

First, a semiconductor integrated circuit and a method of diagnosing a failure symptom in the semiconductor integrated circuit, according to a first embodiment of the invention will be described with reference to FIGS. 1 to 8.

The semiconductor integrated circuit according to the first embodiment is mounted on an electronic control board (for example, an electronic control unit (ECU)). Then, the semiconductor integrated circuit according to the first embodiment diagnoses a symptom of failure of a main function circuit unit included in the semiconductor integrated circuit by using a power supply current detected in a state where a circuit activation ratio of the main function circuit unit is high, thereby making it possible to comprehensively perform symptom diagnosis on main function circuits in the semiconductor integrated circuit. The semiconductor integrated circuit according to the first embodiment can diagnose a symptom of failure of the semiconductor integrated circuit with a single parameter (for example, the power supply current), and thus the symptom can be diagnosed even in a short time such as the time of activation of the semiconductor integrated circuit.

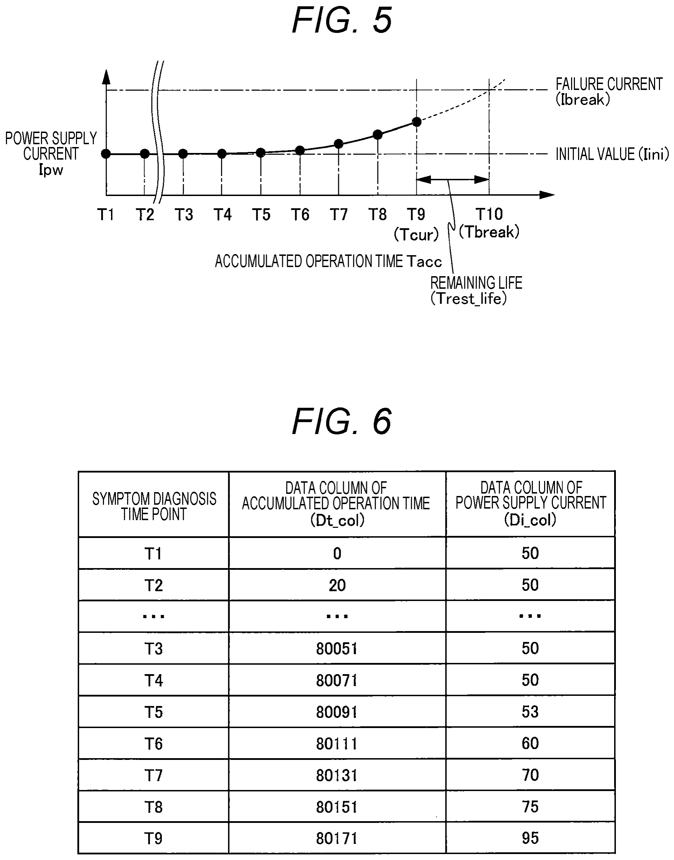

In the ECU according to the first embodiment, a symptom diagnosis unit provided in the semiconductor integrated circuit calculates a remaining life Trest_life until a current reaches a failure current Ibreak (see FIG. 5 to be described later) by using time-series data in which a power supply current Ipw and an accumulated operation time acquired in a state where the circuit activation ratio of the main function circuit unit is increased are stored in association with each other. The symptom diagnosis unit is allowed to diagnose, on the basis of the calculated remaining life Trest_life, presence or absence of a symptom of failure of the main function circuit unit before the main function circuit unit fails. In the following description, an operation in which the symptom diagnosis unit diagnoses presence or absence of a symptom of failure of the main function circuit unit is also simply referred to as "diagnose a symptom".

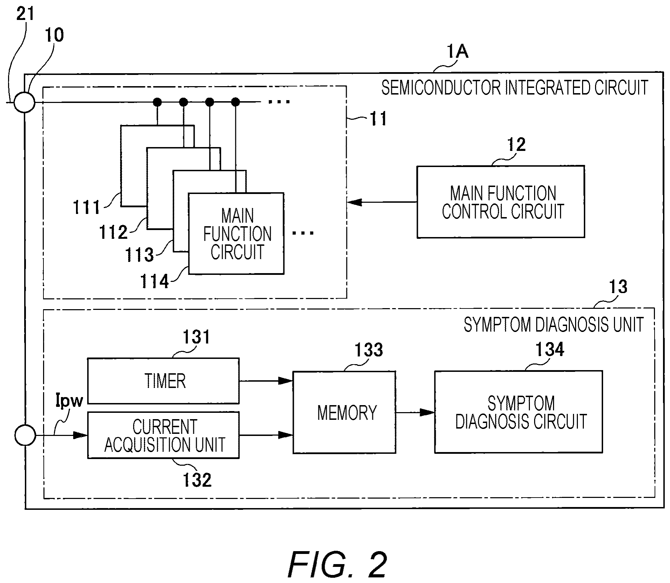

Note that the time-series data includes a data pair of a power supply current and an accumulated operation time associated with the power supply current, and is treated as the time-series data when there is one or more data pairs. The circuit activation ratio is defined as a ratio of the number of operating main function circuits to the total number of main function circuits. For example, the circuit activation ratio can be obtained when at least one of main function circuits 111 to 114 mounted on a main function circuit unit 11 of a semiconductor integrated circuit 1A illustrated in FIG. 2 to be described later is activated, that is, in an operating state. A state where the circuit activation ratio is high indicates a state in which the circuit activation ratio is higher than a maximum activation ratio when the main function circuit unit 11 operates normally.

For example, it is assumed that the main function circuit unit 11 includes four main function circuits 111 to 114. Further, it is assumed that when the maximum activation ratio during normal operation of the main function circuit unit 11 is 75%, the main function circuits 111 to 113 are in operation and the main function circuit 114 is not in operation. At the time of the symptom diagnosis performed by a symptom diagnosis unit 13, an operation mode is switched to a diagnosis mode, and the main function circuit unit 11 operates in an operation state where a current flows through all the main function circuits 111 to 114.

Configuration examples and operation examples of the semiconductor integrated circuit 1A and an ECU 2 on which the semiconductor integrated circuit 1A is mounted will be described below with reference to FIGS. 1 and 2.

FIG. 1 is a block diagram illustrating an internal configuration example of the ECU 2, according to the first embodiment, on which the semiconductor integrated circuit 1A according to the first embodiment is mounted.

In the ECU 2, the ECU 2 operates with power supplied from an external battery 7. In addition, the ECU 2 appropriately outputs drive signals for driving external loads 6 to the loads 6. The ECU 2 includes the semiconductor integrated circuit 1A, a power supply circuit 3, a current detection circuit 4, and a drive circuit 5.

The power supply circuit 3 converts power supplied from the battery 7, and supplies the power to the semiconductor integrated circuit 1A and the drive circuit 5.

The current detection circuit 4 detects the power supply current Ipw flowing through the semiconductor integrated circuit 1A, from power supplied from the power supply circuit 3 to the semiconductor integrated circuit 1A. As an example of the current detection circuit 4, a configuration with a resistor 41 and a detection circuit 42 illustrated in FIG. 1 is conceivable. The resistor 41 is connected to a power supply line 21 wired between the power supply circuit 3 and the semiconductor integrated circuit 1A, detects the power supply current Ipw, and outputs the detected power supply current Ipw as a voltage. The detection circuit 42 detects a voltage generated across the resistor 41, and outputs the voltage to the semiconductor integrated circuit 1A.

The semiconductor integrated circuit 1A is an example of a circuit in which a plurality of semiconductors are integrated. The semiconductor integrated circuit 1A generates an optimum load drive signal for driving the load 6 on the basis of information related to a vehicle. The load drive signal generated by the semiconductor integrated circuit 1A is output to the drive circuit 5 as a drive command.

The drive circuit 5 outputs a drive signal to the load 6 on the basis of the drive command from the semiconductor integrated circuit 1A.

<Internal configuration example of semiconductor integrated circuit>

Next, an internal configuration example of the semiconductor integrated circuit according to the first embodiment will be described.

FIG. 2 is a block diagram illustrating an internal configuration example of the semiconductor integrated circuit 1A. The semiconductor integrated circuit 1A performs symptom diagnosis on the main function circuit unit 11 on the basis of the time-series data including the power supply current Ipw and the accumulated operation time in the semiconductor integrated circuit 1A.

The semiconductor integrated circuit 1A includes a power supply terminal 10, the main function circuit unit 11, a main function control circuit 12, and the symptom diagnosis unit 13.

The power supply terminal 10 is connected to the power supply line 21. Power is supplied to the power supply terminal (power supply terminal 10) from the external power supply (battery 7). Then, the power supply terminal 10 outputs the power of the battery 7 to each unit in the semiconductor integrated circuit 1A via the power supply line 21 (see FIG. 1).

The circuit unit (main function circuit unit 11) includes a plurality of circuits, and the plurality of circuits operates at a predetermined activation ratio, with power supplied from the power supply terminal (power supply terminal 10). The main function circuit unit 11 has a main function such as generating the load drive signal for the load 6. The main function circuit unit 11 is a circuit group including various circuits necessary for generating the load drive signal during the normal operation, performing an initialization operation at the time of activation of the semiconductor integrated circuit 1A, performing a hardware self-diagnosis operation, or the like. The main function circuit unit 11 includes the main function circuits 111 to 114, which are an example of a plurality of semiconductor circuits. Each of the main function circuits 111 to 114 individually operates with power supplied through the power supply line 21.

The main function control circuit 12 controls the operation of the main function circuit unit 11. The main function control circuit 12 has a function of controlling a circuit operation in accordance with an activation sequence at the time of activation of the semiconductor integrated circuit 1A, and a function of controlling a circuit activation ratio at the time of symptom diagnosis. The main function control circuit 12 performs individual control on each of the operations of the main function circuits 111 to 114 in accordance with the operation modes. In a normal mode, the main function control circuit 12 selects and operates a necessary main function circuit from the main function circuits 111 to 114.

On the other hand, in the diagnosis mode, the main function control circuit 12 operates all of the main function circuits 111 to 114. In addition, in the diagnosis mode, the main function control circuit 12 notifies the symptom diagnosis unit 13 of the fact that the mode is in the diagnosis mode. The symptom diagnosis unit 13 receives a notification from the main function control circuit 12 to perform symptom diagnosis. In the following description, performing symptom diagnosis on the main function circuit unit 11 is synonymous with performing symptom diagnosis on the semiconductor integrated circuit 1A. In addition, the symptom diagnosis on the semiconductor integrated circuit 1A needs to be performed so as not to affect the normal use of the semiconductor integrated circuit 1A. Therefore, the diagnosis of a failure symptom in the diagnosis mode is performed at the time of activation of or at the time of termination of the semiconductor integrated circuit (semiconductor integrated circuit 1A).

The symptom diagnosis unit 13 has a function of diagnosing a failure symptom in the semiconductor integrated circuit 1A. The symptom diagnosis unit 13 includes a timer 131, a current acquisition unit 132, a memory 133, and a symptom diagnosis circuit 134. When the semiconductor integrated circuit 1A is in the diagnosis mode, the symptom diagnosis unit 13 operates.

The timer (timer 131) measures an accumulated operation time in which a time during which the circuit unit (main function circuit unit 11) operates is accumulated. For example, the timer 131 determines, as the operation time of the semiconductor integrated circuit 1A, a time during which the semiconductor integrated circuit 1A is activated, that is, a time during which a power supply voltage is applied to the power supply terminal of the semiconductor integrated circuit 1A, and measures an accumulated operation time Tacc obtained by accumulating the operation time. The main function circuit unit 11 operates while the semiconductor integrated circuit 1A is activated, and thus the operation time is accumulated in the accumulated operation time Tacc. Then, the timer 131 outputs data of the accumulated operation time Tacc to the memory 133. Note that the timer 131 may read the accumulated operation time Tacc from the memory 133 at the time of activation of the semiconductor integrated circuit 1A, accumulate a time in the read accumulated operation time Tacc while the semiconductor integrated circuit 1A is activated, and output the accumulated operation time Tacc to the memory 133 when the semiconductor integrated circuit 1A is stopped.

The current acquisition unit (current acquisition unit 132) acquires, from the power supply terminal (power supply terminal 10), consumption current of power consumed in the circuit unit (main function circuit unit 11). For example, the current acquisition unit 132 acquires a power supply current in a state where the circuit activation ratio of the main function circuit unit 11 is high. The power supply current acquired by the current acquisition unit 132 is represented by a voltage Vsense_pw output by the current detection circuit 4 illustrated in FIG. 1 on the basis of the power supply current Ipw. The current acquisition unit 132 includes, for example, an analog to digital converter (ADC). The current acquisition unit 132 converts the voltage Vsense_pw detected by the current detection circuit 4 into data, and outputs the data to the memory 133. A timing at which the current acquisition unit 132 acquires the power supply current Ipw is at the time of activation of or at the time of termination of the semiconductor integrated circuit 1A, in order not to affect the normal operation of the semiconductor integrated circuit 1A. However, the current acquisition unit 132 can periodically acquire the power supply current Ipw, within a range not affecting the normal operation.

The memory (memory 133) stores the time-series data of the consumption current and the accumulated operation time acquired in the diagnosis mode. For example, the memory 133 stores time-series data that is data in which the power supply current Ipw is associated with the accumulated operation time Tacc at a timing at which the current acquisition unit 132 acquires the power supply current Ipw. A period during which the memory 133 stores the accumulated operation time Tacc is desirably several months to several years. Therefore, as the memory 133, a nonvolatile storage medium is used such as a flash memory capable of storing data even in a power-off state.

The symptom diagnosis circuit (symptom diagnosis circuit 134) diagnoses a failure symptom in the circuit unit (main function circuit unit 11) on the basis of the time-series data of the consumption current and the accumulated operation time acquired on a time-series basis in the diagnosis mode in which the circuit unit (main function circuit unit 11) operates at an activation ratio higher than the maximum activation ratio of the circuit unit (main function circuit unit 11) operating normally. Then, the symptom diagnosis circuit (symptom diagnosis circuit 134) calculates a time until the consumption current acquired in the diagnosis mode reaches a symptom diagnosis threshold, on the basis of the time-series data of the consumption current and the accumulated operation time, and predicts a failure occurrence timing of the circuit unit (main function circuit unit 11).

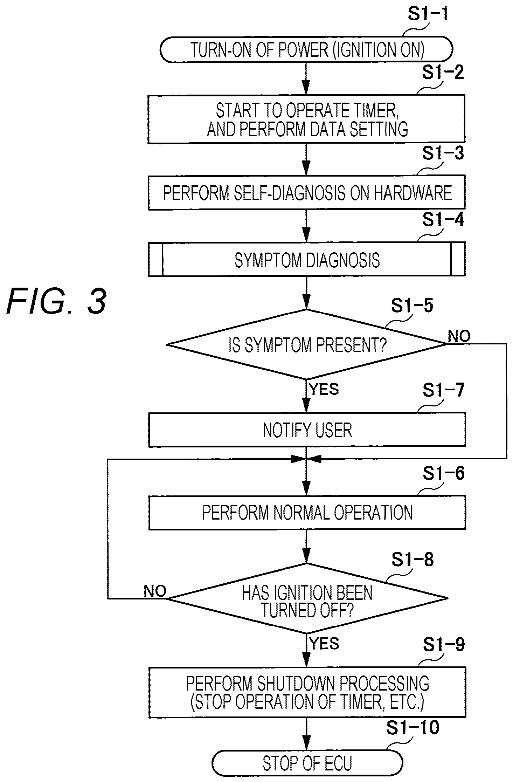

For example, the symptom diagnosis circuit 134 obtains temporal transition of the power supply current Ipw on the basis of the time-series data of the power supply current Ipw and the accumulated operation time Tacc stored in the memory 133 at the time of symptom diagnosis. Then, the symptom diagnosis circuit 134 calculates the remaining life Trest_life of the semiconductor integrated circuit 1A, and then diagnoses presence or absence of a failure symptom in the semiconductor integrated circuit 1A by using the remaining life Trest_life. The failure symptom is an indication that appears before failure occurs in the semiconductor integrated circuit. For example, the failure symptom is an indication that any of the main function circuits 111 to 114 deteriorates and the power supply current Ipw approaches the failure current Ibreak. The presence or absence of the failure symptom is diagnosed on the basis of a relationship between the remaining life Trest_life and a symptom diagnosis threshold Tth_symptom illustrated in FIG. 3.

<Example of symptom diagnosis processing>

Next, an example of processing for performing the symptom diagnosis on the semiconductor integrated circuit 1A will be described.

FIG. 3 is a flowchart illustrating an example of processing in which symptom diagnosis on the semiconductor integrated circuit 1A is performed at the time of activation of the semiconductor integrated circuit 1A. In FIG. 3, processing performed between activation and termination of the semiconductor integrated circuit 1A will be described.

When a user turns on the power of the vehicle (turns on the ignition switch), this processing is started, and the semiconductor integrated circuit 1A is activated (S1-1). Then, power supplied from the battery 7 is started to be supplied to the semiconductor integrated circuit 1A via the power supply circuit 3, and the processing proceeds to S1-2.

Next, the timer 131 for acquiring the accumulated operation time Tacc is started to be operated, data setting on an initial value for a register in the semiconductor integrated circuit 1A is performed, and other processing is performed (S1-2), and the processing proceeds to S1-3.

Next, the semiconductor integrated circuit 1A performs self-diagnosis on hardware in the semiconductor integrated circuit 1A (S1-3), and the processing proceeds to S1-4. Here, the semiconductor integrated circuit 1A checks whether or not the symptom diagnosis circuit 134 operates normally in addition to the main function circuits 111 to 114.

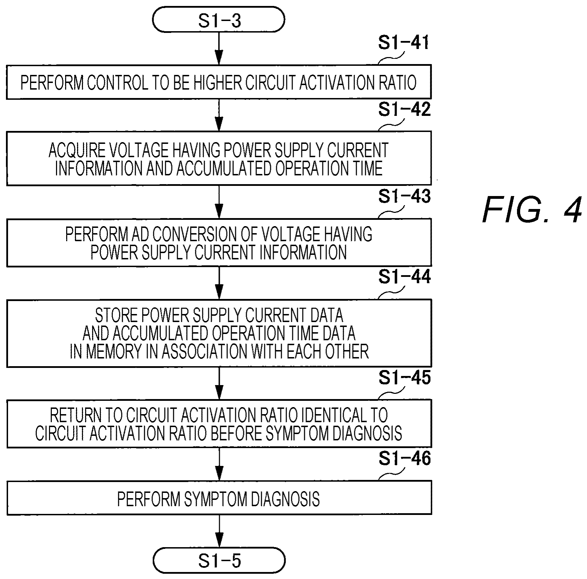

Next, the symptom diagnosis unit 13 of the semiconductor integrated circuit 1A performs symptom diagnosis on the semiconductor integrated circuit 1A through the diagnosis mode (S1-4), and calculates the remaining life Trest_life. Details of the processing of S1-4 will be described later with reference to FIG. 4.

After S1-4, the symptom diagnosis unit 13 determines whether or not there is a symptom of presence of failure in the main function circuit unit 11 (S1-5). Here, the symptom diagnosis unit 13 performs the symptom diagnosis by comparing the remaining life Trest _life with the symptom diagnosis threshold Tth_symptom. In a case where the remaining life Trest _life is shorter than the symptom diagnosis threshold Tth_symptom, the symptom diagnosis unit 13 diagnoses that a symptom is present (YES in S1-5), and the processing proceeds to S1-7. On the other hand, in a case where the remaining life Trest _life is equal to or longer than the symptom diagnosis threshold Tth_symptom, the symptom diagnosis unit 13 diagnoses that there is no symptom (NO in S1-5), and the processing proceeds to S1-6.

After the YES determination in S1-5, the symptom diagnosis unit 13 notifies the user of the vehicle of information indicating that a failure symptom is present in the main function circuit unit 11 through an in-vehicle warning light or the like (S1-7), and the processing proceeds to S1-6. Note that the vehicle can travel even after the symptom diagnosis unit 13 diagnoses that a symptom is present in the main function circuit unit 11. For this reason, as a possible response of the user, the user is assumed to cause the vehicle to travel by its own power, and request a repair shop to inspect or replace the ECU 2. However, in a case where it is determined that a symptom is present during traveling of the vehicle, the user may immediately stop traveling of the vehicle and request a repair shop to move the vehicle by using a tow truck.

After the NO determination in S1-5 or after S1-7, the semiconductor integrated circuit 1A performs the normal operation in the normal operation mode (S1-6). During the normal operation of the semiconductor integrated circuit 1A, a voltage abnormality detection circuit (not illustrated) included in the main function circuit unit 11 monitors power supply voltage Vpw of the main function circuits 111 to 114. In a case where the power supply voltage Vpw becomes lower than a voltage threshold Vmin_ope, which is the minimum voltage at which the main function circuits 111 to 114 can operate, the main function control circuit 12 executes shutdown processing of the main function circuits 111 to 114.

Next, the semiconductor integrated circuit 1A determines whether or not the ignition has been turned off (S1-8). Here, the semiconductor integrated circuit 1A determines whether or not the user has turned off the ignition of the vehicle by comparing the power supply voltage Vpw with the low voltage threshold Vmin_ope. When the ignition is turned off, the voltage supply from the battery 7 to the ECU 2 is stopped, and the power supply voltage Vpw becomes lower than the low voltage threshold Vmin_ope.

Thus, in a case where the power supply voltage Vpw is equal to or higher than the low voltage threshold Vmin_ope, the semiconductor integrated circuit 1A determines that the ignition has not been turned off (NO in S1-8), and the processing proceeds to S1-6, continuing the normal operation. On the other hand, in a case where the power supply voltage Vpw is lower than the low voltage threshold Vmin_ope, the semiconductor integrated circuit 1A determines that the ignition has been turned off (YES in S1-8), and stops the normal operation such as generation of the load drive signal, and the processing proceeds to S1-9.

After the YES determination in S1-8, the semiconductor integrated circuit 1A performs a series of shutdown processing such as storing data that needs to be recorded in the memory 133 and stopping the operation of the timer 131 for acquiring the accumulated operation time Tacc (S1-9). After the shutdown processing is completed, the operations of all the internal circuits of the ECU 2 are stopped (S1-10).

Since the symptom diagnosis processing illustrated in step S1-4 of FIG. 3 is performed in a state where the circuit activation ratio of the main function circuit unit 11 is high, it is preferable to perform the symptom diagnosis processing after S1-3 in which all the hardware (internal circuits) becomes operable as described above.

In addition, in this embodiment, as the processing after the symptom diagnosis, the processing of notifying the user of the information indicating the presence of a failure symptom has been described. However, in a case where the semiconductor integrated circuit 1A is connected to an external system via communication such as over-the-air (OTA), the symptom diagnosis unit 13 may notify the external system of the information indicating the presence of a failure symptom.

In addition, in this embodiment, the processing of notifying the user of the information indicating the presence of a failure symptom has been described. However, the symptom diagnosis unit 13 may notify the user of the remaining life Trest_life every time the symptom diagnosis unit 13 performs the symptom diagnosis.

In addition, the flowchart illustrated in FIG. 3 is an example of an activation flow of the semiconductor integrated circuit 1A according to this embodiment. However, the content or order of the processing may be different for each semiconductor integrated circuit, and some processing may be added or deleted. Note that in this embodiment, an example is described in which symptom diagnosis is performed at the time of activation of the semiconductor integrated circuit 1A. However, the symptom diagnosis may be performed at the time of termination of the semiconductor integrated circuit 1A. In addition, the symptom diagnosis may be periodically performed during the normal operation, within a range not affecting the normal operation.

<Processing of symptom diagnosis>

Next, an example of detailed processing of the symptom diagnosis (S1-4 in the flowchart of FIG. 3) will be described.

FIG. 4 is a flowchart illustrating an example of processing, of the symptom diagnosis, in which the symptom diagnosis unit 13 of the semiconductor integrated circuit 1A performs the symptom diagnosis. As described above, the symptom diagnosis processing is started when the hardware self-diagnosis (S1-3) is completed. As described above, the processing of the symptom diagnosis illustrated in FIG. 4 is performed in the diagnosis mode.

First, the main function control circuit 12 performs, on the circuit activation ratio of the main function circuit unit 11, control to be in a state higher than the circuit activation ratio during the normal operation of the semiconductor integrated circuit (S1-41), and the processing proceeds to S1-42. Here, control to cause the current to flow through all of the main function circuits 111 to 114 is referred to as "control to be in a state higher than the circuit activation ratio during the normal operation".

Next, the current acquisition unit 132 of the symptom diagnosis unit 13 simultaneously performs processing of acquiring the voltage Vsense_pw having power supply current information from the current detection circuit 4, and processing of acquiring accumulated operation time data Dt from the timer 131 (S1-42), and the processing proceeds to S1-43. "Having the power supply current information" means that since the voltage is measured in proportion to the power supply current, the current acquisition unit 132 can detect the power supply current from the magnitude of the voltage.

Processing in which the timer 131 stores the accumulated operation time data Dt in the memory 133 is not simultaneous with processing in which the current acquisition unit 132 acquires the voltage Vsense_pw, due to a time for converting the accumulated operation time Tacc into the accumulated operation time data Dt. However, the acquisition timing of the voltage Vsense_pw and the acquisition timing of the accumulated operation time data Dt are the same timing. In general, for data input to the ADC used for the current acquisition unit 132, a circuit, such as a sample and hold circuit, is used that temporarily holds acquired data. In a case where control is performed such that the timing at which the voltage Vsense_pw having the power supply current information is acquired by using the sample and hold circuit and the timing at which the accumulated operation time data Dt is acquired are the same timing, the processing of acquiring the voltage Vsense_pw having the power supply current information from the current detection circuit 4 and the processing of acquiring the accumulated operation time data Dt from the timer 131 may be regarded as being simultaneously performed.

Next, the current acquisition unit 132 performs AD conversion of the voltage Vsense_pw having the power supply current information into power supply current data Di storable in the memory 133 (S1-43), and the processing proceeds to S1-44.

Next, the current acquisition unit 132 stores the power supply current data Di and the accumulated operation time data Dt in the memory 133 in association with each other (S1-44), and the processing proceeds to S1-45.

Next, the main function control circuit 12 returns the mode to the normal mode from the diagnosis mode. Then, the main function control circuit 12 returns the circuit activation ratio of the main function circuit unit 11 to the circuit activation ratio during the normal operation (S1-45), and the processing proceeds to S1-46.

Next, the symptom diagnosis circuit 134 performs symptom diagnosis for calculating the remaining life Trest_life (S1-46), and the processing proceeds to S1-5 in FIG. 3. In this symptom diagnosis, the symptom diagnosis circuit 134 reads necessary data from a data column Di_col of the power supply current including the past power supply current data Di, and a data column Dt_col of the accumulated operation times at time points when the current acquisition unit 132 acquires respective power supply currents, configured in the memory 133 and illustrated in FIG. 6 to be described later. Then, the symptom diagnosis circuit 134 calculates the remaining life Trest_life until the power supply current reaches the failure current Ibreak, on the basis of the data read from the data column Di_col of the power supply currents and the data column Dt_col of the accumulated operation times. The failure current Ibreak is a current value detected when it is diagnosed that the main function circuit unit 11 has definitely failed. Processing in which the symptom diagnosis circuit 134 calculates the remaining life Trest_life will be described later.

Note that the symptom diagnosis circuit 134 is unable to perform the symptom diagnosis on a main function circuit that is not activated in the control of S1-41 because it is not possible to grasp the temporal transition of the consumption current by using the power supply current, for the non-activated main function circuit. Therefore, as the circuit activation ratio in the main function circuit unit 11 based on the control in S1-41 is higher, the number of main function circuits for which a symptom is grasped by using the power supply current is larger, and thus the comprehensiveness of the symptom diagnosis is higher.

<Processing in which symptom diagnosis circuit calculates remaining life>

Next, with reference to FIGS. 5 and 6, description will be made for an example of processing in which the symptom diagnosis circuit 134 calculates the remaining life Trest _life on the basis of the data of the data column Dt_col of the accumulated operation times and the data of the data column Di_col of the power supply currents, illustrated in the symptom diagnosis in S1-46 of FIG. 4. Note that the data illustrated in each of FIGS. 5 and 6 is created to perform symptom diagnosis on the main function circuit unit 11.

FIG. 5 is a graph illustrating how the power supply current Ipw changes with respect to the accumulated operation time Tacc. In the graph illustrated in FIG. 5, the time-series data (Dt_col, Di_col) illustrated in FIG. 6 is illustrated while the accumulated operation time Tacc is plotted as the X-axis and the power supply current Ipw is plotted as the Y-axis. Note that contents plotted in this graph are time-series data (Dt_col, Di_col) illustrated in FIG. 6, which is stored in the memory 133 from a use start time point (Tacc = T1 = 0) of the semiconductor integrated circuit 1A to a present time point (T9). A time point (T10) that is a predicted failure occurrence time point (Tbreak) is later than the time point (T9) that is a present time point (Tcur), but is illustrated in FIG. 5 for description of the remaining life Trest _life and the failure current Ibreak.

FIG. 6 is a table illustrating the contents of the time-series data (Dt_col, Di_col) stored in the memory 133. In the memory 133, the data of the data column Dt_col of the accumulated operation time and the data of the data column Di_col of the power supply current are stored in order of T1, T2,..., and T9 each of which is a time point when the symptom diagnosis is performed.

At the present time point (T9), in the semiconductor integrated circuit 1A, it is assumed that the consumption current of the main function circuit unit 11 starts to increase due to variation in characteristics over time. The reason why the consumption current starts to increase is that deterioration in which the consumption current increases occur in the main function circuit unit 11 with an increase in the accumulated operation time Tacc. When the deterioration in which the consumption current increases occur in the main function circuit unit 11 as described above, the power supply current Ipw consumed in the main function circuit unit 11 also increases. Therefore, by storing the power supply current Ipw and the accumulated operation time Tacc in the memory 133 in association with each other, the symptom diagnosis circuit 134 can grasp a tendency of the temporal transition of the power supply current Ipw due to the variation over time in characteristics of the main function circuit unit 11.

That is, the symptom diagnosis circuit 134 can predict future temporal transition from the tendency of the temporal transition of the power supply current Ipw. Then, the symptom diagnosis circuit 134 can calculate the time Tbreak until the power supply current Ipw reaches the failure current Ibreak, on the basis of the predicted temporal transition. As an example of a method of calculating the future temporal transition from the tendency of the temporal transition, there is a method using an approximate expression.

In this embodiment, as an example of the approximate expression, description will be made for a method of performing prediction by using exponential approximation in which the accumulated operation time is x and the power supply current is y, expressed in the following expression (1) .

$$y = a \times e^{(bx)} \cdots (1)$$

In the expression (1), e is a Napier's constant, and a and b are coefficients in exponential approximation. In addition, x is the accumulated operation time Tacc, and y is the power supply current Ipw.

Here, it is assumed that the symptom diagnosis circuit 134 performs the symptom diagnosis at each of the time points of the accumulated operation times T1 to T9 in FIG. 5. Then, it is assumed that the time-series data (Dt_col, Di_col) illustrated in FIG. 6 used for the symptom diagnosis is stored in the memory 133. On the basis of these assumptions, a method in which the symptom diagnosis circuit 134 calculates the remaining life Trest_life will be described. Note that a method of calculating the coefficients in the approximate expression is known, and thus description thereof will be omitted.

First, the symptom diagnosis circuit 134 calculates the coefficients a, b in the expression (1) from the time-series data (Dt_col, Di_col) read from the memory 133 by using its data at and after T4 that is immediately before a start of deterioration, as a result of which a = 47.646 and b = 0.008 are obtained. In the approximate expression to which the coefficients a, b are applied, x at which y is the failure current Ibreak is an accumulated operation time at the time when the current reaches the failure current, that is, the accumulated operation time Tbreak at which the life expires.

Therefore, the symptom diagnosis circuit 134 can calculate the accumulated operation time Tbreak by obtaining x at which y = failure current Ibreak. In addition, the symptom diagnosis circuit 134 can obtain, as the remaining life Trest_life, a difference between the accumulated operation time Tbreak and an accumulated operation time Tcur at the present time point. For example, if Tcur = T9, the symptom diagnosis circuit 134 calculates T10 - T9 as the remaining life Trest_life. In this manner, the symptom diagnosis circuit 134 can calculate the remaining life Trest _life by using the time-series data and the approximate expression (1).

As illustrated in FIG. 5, the failure current Ibreak is set to a value larger than an initial value Iini. The symptom diagnosis circuit 134 calculates the remaining life Trest_life until the power supply current Ipw reaches the failure current Ibreak, thereby enabling symptom diagnosis effective for a deterioration mode in which the power supply current Ipw increases.

On the other hand, when the main function circuit unit 11 deteriorates, there is a case in which the power supply current Ipw may have a characteristic of decreasing. In this case, the failure current Ibreak is set to a value smaller than the initial value Iini. Then, the symptom diagnosis circuit 134 may calculate the remaining life Trest _life until the power supply current Ipw reaches the failure current Ibreak. In this case, the symptom diagnosis is effective for a deterioration mode in which the power supply current Ipw decreases. Further, the symptom diagnosis circuit 134 may set the failure current Ibreak to both a larger value and a smaller value than the initial value Iini such that the detection can be made in both the deterioration mode in which the power supply current Ipw increases and the deterioration mode in which the power supply current Ipw decreases.

Note that regarding the failure current Ibreak, the failure current Ibreak may be set at the time of manufacturing the semiconductor integrated circuit 1A, and the failure current Ibreak may be set to be unchangeable after the semiconductor integrated circuit 1A is mounted in the vehicle. In addition, in a case where the semiconductor integrated circuit 1A is connected to an external system via OTA or the like, the failure current Ibreak may be set to be changeable by a value received from the external system even after the semiconductor integrated circuit 1A is mounted in the vehicle.

<Processing of changing symptom diagnosis threshold>

In addition, in a case where the slope of the time-series data is steeper than a predetermined slope, the symptom diagnosis threshold Tth_symptom may be changed.

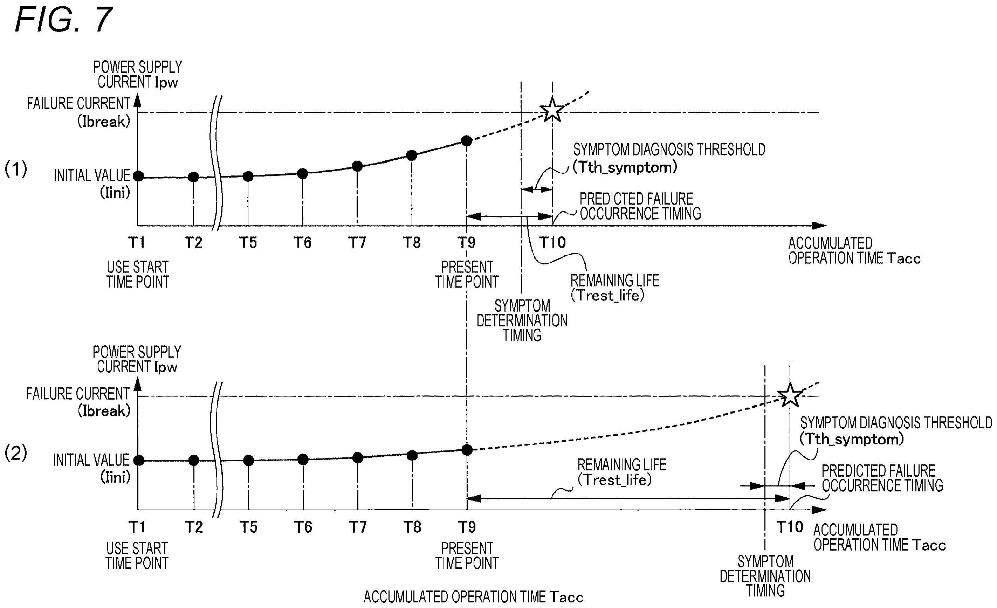

FIG. 7 is a diagram illustrating examples in each of which the symptom diagnosis circuit 134 sets a symptom diagnosis threshold. The graph (1) in FIG. 7 illustrates an example of a change in the power supply current Ipw in a case where a deterioration rate of the main function circuit unit 11 is high. In addition, the graph (2) in FIG. 7 illustrates an example of a change in the power supply current Ipw in a case where the deterioration rate of the main function circuit unit 11 is normal. In addition, each of star-shaped marks in the drawing represents a predicted failure occurrence timing at which the power supply current Ipw reaches the failure current Ibreak.

In a case where the deterioration rate of the main function circuit unit 11 is normal, as illustrated in the graph (2) in FIG. 7, even if the power supply current Ipw increases, the remaining life Trest _life until the power supply current Ipw reaches the failure current Ibreak is sufficiently long. Moreover, the symptom diagnosis threshold Tth_symptom is set to a predetermined value. Thus, a timing of determining the failure symptom for the user is set to a timing earlier by the symptom diagnosis threshold Tth_symptom from a predicted failure occurrence timing (T10).

On the other hand, in a case where the deterioration rate of the main function circuit unit 11 is high, the power supply current Ipw increases in a short period as illustrated in the graph (1) in FIG. 7. Therefore, the remaining life Trest _life until the power supply current Ipw reaches the failure current Ibreak in this case is shorter than the remaining life Trest_life illustrated in the graph (2) in FIG. 7. However, if an action to repair the main function circuit unit 11 is not taken until the predicted failure occurrence timing, the vehicle may stop at a timing not intended by the user. Therefore, in consideration of safety, the symptom diagnosis circuit 134 needs to notify the user of a failure symptom at a timing earlier than normal or to change a vehicle control method.

Therefore, the symptom diagnosis circuit (symptom diagnosis circuit 134) changes the symptom diagnosis threshold in accordance with the slope of the consumption current with respect to the accumulated operation time of the time-series data. For example, in a case where the rate of deterioration progression is high, the symptom diagnosis circuit 134 changes the symptom diagnosis threshold Tth_symptom while focusing on the fact that the slope of the time-series data is steep. For example, in a case where a slope between two time points (T8 and T9) immediately before a time during which the slope of the time-series data is calculated is "5" or more, the symptom diagnosis circuit 134 sets the symptom diagnosis threshold Tth_symptom to a value larger than the original value illustrated in the graph (2) in FIG. 7. Note that the slope between T8 and T9 is expressed by the following expression.

The slope between T8 and T9 = [Di_col (T9) - Di_col (T8)]/[Dt_col (T9) - Dt_col (T8)]

In this manner, the symptom diagnosis circuit 134 sets the symptom diagnosis threshold Tth_symptom to be large in a case where the slope of the time-series data becomes steeper than normal. In other words, the symptom diagnosis circuit 134 increases the symptom diagnosis threshold Tth_symptom as the rate of deterioration progression increases. Therefore, the symptom diagnosis circuit 134 can perform safety control such as notifying the user of a failure symptom at a timing earlier than normal or changing a vehicle control method.

<Modification example of power supply current data stored in memory>

Further, alternatively, all the power supply current data acquired in the past symptom diagnosis need not be stored in the memory 133, and only the power supply current data effective for symptom diagnosis may be stored in the memory 133. For example, in a period from T2 to T3 in FIG. 5, since the variation over time in characteristics of the main function circuit unit 11 is unable to be confirmed, the power supply current data in the period from T2 to T3 need not be left in the memory 133. On the other hand, the memory 133 stores a value of an initial current at T1 necessary for calculating the coefficient of the approximate expression (1), data of the power supply current acquired at (T4) immediately before T5 at which the variation over time in characteristics of the semiconductor integrated circuit 1A is observed, and data of the accumulated operation time Tacc and the power supply current Ipw acquired at and after T4. By limiting the data stored in the memory 133, only data necessary for symptom diagnosis can be held in the memory 133, and an amount of data in the memory 133 can be saved.

The method described above is a method in which the symptom diagnosis circuit 134 performs symptom diagnosis from the remaining life Trest_life obtained by calculating the accumulated operation time Tbreak at which the current reaches the failure current Ibreak, on the basis of the time-series data (Dt_col, Di_col) in the memory 133. In the case of this symptom diagnosis method, it is necessary to store the accumulated operation time Tacc corresponding to the power supply current Ipw in the memory 133, in accordance with the symptom diagnosis performed by the symptom diagnosis circuit 134. Therefore, the memory 133 needs to be a rewritable memory.

<Example of semiconductor integrated circuit on which memory is not mounted>

On the other hand, with respect to a semiconductor integrated circuit on which the rewritable memory 133 is not mounted, the symptom diagnosis circuit 134 may perform symptom diagnosis by using a method described below. First, the symptom diagnosis circuit 134 obtains a difference between an initial value of a power supply current acquired at the time when the semiconductor integrated circuit is manufactured and a power supply current acquired when the semiconductor integrated circuit is mounted on the vehicle and used. Thereafter, the symptom diagnosis circuit 134 performs symptom diagnosis on the basis of the difference in the power supply current and the accumulated operation time Tacc. In this method, the initial value Iini of the power supply current acquired in a manufacturing process is recorded in a read only memory (ROM) such as a one-time programmable (OTP) ROM. By recording the initial value Iini in the ROM, it is not necessary to store the power supply current Ipw acquired for each symptom diagnosis and the accumulated operation time Tacc at the acquisition time point in the rewritable memory 133, and thus the memory 133 is unnecessary.

<Method of calculating remaining life based on relationship between two points>

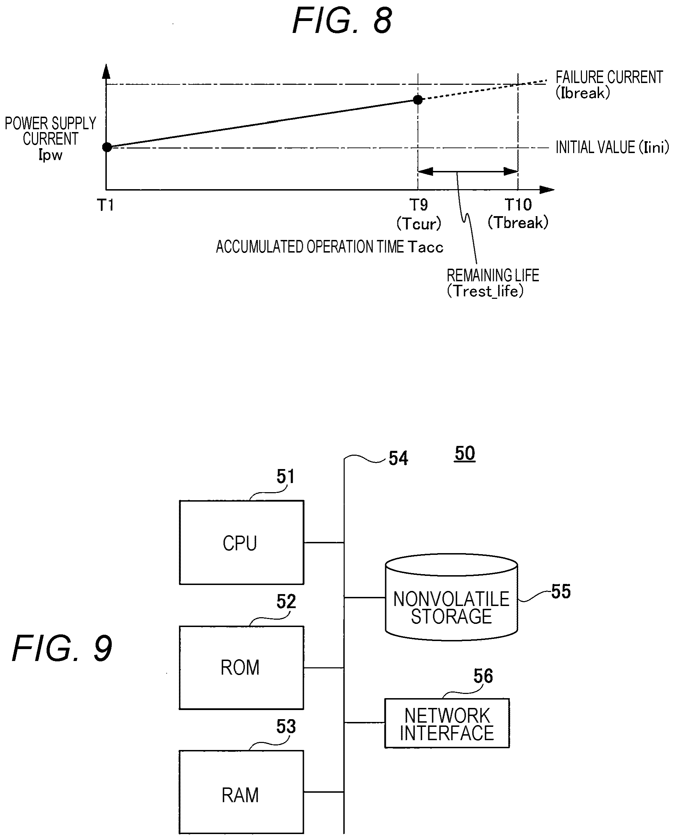

Further, in a case where the memory 133 is unnecessary in the semiconductor integrated circuit 1A illustrated in FIG. 2, the accumulated operation time data Dt acquired by the timer 131 and the power supply current data Di acquired by the current acquisition unit 132 are directly input to the symptom diagnosis circuit 134, and the symptom diagnosis is performed. Here, with reference to FIG. 8, an operation example will be described in which the symptom diagnosis circuit 134 performs symptom diagnosis by using the initial value Iini of the power supply current, and the power supply current data Di and the accumulated operation time data Dt acquired in the symptom diagnosis. Note that an operation example for the symptom diagnosis circuit 134 will be described assuming that the present time point (Tcur) at which the symptom diagnosis is performed is the time point of T9.

FIG. 8 is a diagram illustrating an example in which the symptom diagnosis circuit 134 performs symptom diagnosis on the semiconductor integrated circuit 1A on the basis of a relationship between power supply currents acquired at respective two different points in timing. In this example, the symptom diagnosis circuit 134 calculates a remaining life on the basis of a relationship between two points of the initial value of the power supply current and a value of a power supply current acquired after a predetermined period has elapsed, and performs symptom diagnosis on the semiconductor integrated circuit 1A. It is assumed that T1, T9, and T10 in FIG. 8 are respectively the same timings as T1, T9, and T10 in FIG. 5.

In this example, the current acquisition unit 132 acquires the initial value Iini of a power supply current at the time when the semiconductor integrated circuit 1A is manufactured (time point of T1). Here, the initial value Iini is set as power supply current data Di1. In addition, after the semiconductor integrated circuit 1A is mounted in the vehicle, the current acquisition unit 132 acquires the power supply current data Di at the time of activation of the semiconductor integrated circuit 1A. Here, a value of the power supply current acquired by the current acquisition unit 132 at the same timing as the time point of T9 illustrated in FIG. 5 is set as power supply current data Di9. In addition, data of the accumulated operation time Tacc at the time point of T9 is set as accumulated operation time data DT9.

The symptom diagnosis circuit 134 can calculate the remaining life from linear approximation between the two points by using the power supply current data Di9, the accumulated operation time data DT9, and the following expression (2). Note that a method of calculating the coefficients in the approximate expression (2) is known, and thus description thereof will be omitted.

$$y = a \times x + b \cdots (2)$$

As the initial value Iini, the same power supply current Ipw and the accumulated operation time Tacc as those at the time point of T1 in FIG. 6 are obtained. Thereafter, the same power supply current Ipw and the accumulated operation time Tacc as those at the time point of T9 in FIG. 6 are obtained. In this case, the coefficients a, b in the expression (2) are obtained as a = 0.00056 and b = 50. A method in which the symptom diagnosis circuit 134 calculates the remaining life Trest _life by using the approximate expression (2) is the same as that in the case where the symptom diagnosis circuit 134 predicts the remaining life on the basis of the exponential approximation using the expression (1), and thus, detailed description thereof will be omitted. According to the method described with reference to FIG. 8, it is unnecessary to mount the rewritable memory 133 on the semiconductor integrated circuit 1A, and it is possible to reduce the circuit area of the semiconductor integrated circuit 1A.

The method using the linear approximation between two points is an effective method in a case where a memory area is unable to be increased in the semiconductor integrated circuit 1A. On the other hand, the method of predicting the remaining life Trest_life by using the expression (2) is linear approximation between two points, and thus the accuracy of the symptom diagnosis is lowered as compared with the remaining life Trest_life calculated on the basis of the exponential approximation of the expression (1). Thus, the memory area and the accuracy of remaining life prediction have a trade-off relationship.

For example, in a case where the approximate expression (2) is used for the time point of T7 (see FIG. 5), which is a timing at which the power supply current Ipw starts to be different from the initial value Iini, the slope of the straight line between the two points is gentle. Therefore, a time until the power supply current Ipw reaches the failure current Ibreak becomes long, and the remaining life Trest_life is likely to be calculated to be longer than that in the case where the approximate expression (1) is used. However, even if the remaining life Trest _life slightly lacks in accuracy, it is an indication of the life of the semiconductor integrated circuit 1A. Therefore, this causes no problem, in terms of allowing the user to know the timing of replacement, repair, or the like of the semiconductor integrated circuit 1A early.

<Hardware configuration example of computer>

Next, a hardware configuration of a computer 50 forming the ECU 2 will be described.

FIG. 9 is a block diagram illustrating a hardware configuration example of the computer 50. The computer 50 is an example of hardware used as a computer operable as the ECU 2 according to this embodiment. The ECU 2 according to this embodiment implements, by the computer 50 (computer) executing a program, a symptom diagnosis method performed by the respective functional units illustrated in FIGS. 3 and 4 in cooperation with each other.

The computer 50 includes a central processing unit (CPU) 51, a read only memory (ROM) 52, and a random access memory (RAM) 53 each connected to a bus 54. Further, the computer 50 further includes a nonvolatile storage 55 and a network interface 56.

The CPU 51 reads a program code of software for implementing each function according to this embodiment from the ROM 52, loads the program code into the RAM 53, and executes the program code. Variables, parameters, and the like generated during calculation processing of the CPU 51 are temporarily written to the RAM 53, and these variables, parameters, and the like are appropriately read by the CPU 51. The functional units of the semiconductor integrated circuit 1A illustrated in FIG. 2 are implemented by the CPU 51. However, a micro processing unit (MPU) or a graphics processing unit (GPU) may be used instead of the CPU 51, or the CPU 51 and a graphics processing unit (GPU) may be used in combination.

As the nonvolatile storage 55, for example, a hard disk drive (HDD), a solid state drive (SSD), an optical disk, a magnetooptical disk, a nonvolatile memory, or the like is used. In addition to an operating system (OS) and various parameters, a program for causing the computer 50 to function is recorded in the nonvolatile storage 55. Each of the ROM 52 and the nonvolatile storage 55 records a program, data, and the like necessary for the operation of the CPU 51, and is used as an example of a non-transitory computer-readable storage medium storing a program to be executed by the computer 50.

For example, as the network interface 56, a network interface card (NIC) or the like is used, and various data can be transmitted and received between ECUs via a controller area network (CAN), a dedicated line, or the like connected with a terminal of the NIC.

In the semiconductor integrated circuit 1A and the ECU 2 according to the first embodiment described above, the symptom diagnosis unit 13 stores the time-series data (Dt_col, Di_col) in the memory 133 in association with the power supply current Ipw and the accumulated operation time Tacc acquired in a state where the circuit activation ratio of the main function circuit unit 11 is increased. Then, the symptom diagnosis circuit 134 obtains the accumulated operation time Tacc until the power supply current Ipw reaches the failure current Ibreak on the basis of the time-series data read from the memory 133, and calculates the remaining life Trest _life until the power supply current Ipw reaches the failure current Ibreak from the difference between the accumulated operation time Tacc and the present time point. Then, the presence or absence of a failure symptom in the main function circuit unit 11 can be diagnosed on the basis of the comparison result between the remaining life Trest_life and the symptom diagnosis threshold Tth_symptom.

When the symptom diagnosis circuit 134 diagnoses that a failure symptom is present, the symptom diagnosis circuit 134 notifies the user of the presence of the failure symptom. Therefore, before the main function circuit unit 11 fails, the user can know the possibility of failure of the main function circuit unit 11, and can take measures such as repair and replacement of the semiconductor integrated circuit 1A including the main function circuit unit 11.

In addition, since a failure symptom is diagnosed for each of many semiconductor integrated circuits 1A mounted in the vehicle, only the semiconductor integrated circuit 1A notified of the failure symptom needs to be repaired or replaced. Therefore, a time and cost required for repairing or replacing the semiconductor integrated circuit 1A can be reduced.

Note that in the first embodiment, an example has been described in which both the processing of acquiring the power supply current Ipw and the accumulated operation time Tacc and the processing of diagnosing a failure symptom are performed at the time of activation of the semiconductor integrated circuit 1A, at which the power is turned on. However, the processing may be performed at different timings. For example, the symptom diagnosis unit 13 may temporarily change the mode to the diagnosis mode during the normal operation of the semiconductor integrated circuit 1A to periodically acquire the power supply current Ipw and the accumulated operation time Tacc, and perform symptom diagnosis at the time of termination of the ECU 2.

In addition, in the first embodiment, the ECU 2 has been described as an example of a system on which the semiconductor integrated circuit 1A is mounted. However, the system on which the semiconductor integrated circuit is mounted need not be limited to the ECU as long as the system is a system on which a semiconductor integrated circuit such as an inverter can be mounted.

In the description so far, the processing has been described in which symptom diagnosis is performed on the main function circuit unit 11 while the main function circuit unit 11 is set as a symptom diagnosis target. This is because a target to which a voltage is applied via the power supply terminal 10 is only the main function circuit unit 11. However, symptom diagnosis may be performed on both the main function circuit unit and a symptom diagnosis circuit unit by allowing a voltage to be also applied via the power supply terminal 10 to the symptom diagnosis circuit unit, in addition to the main function circuit unit. In this case, a current corresponding to the sum of a consumption current in the main function circuit unit and a consumption current in the symptom diagnosis circuit unit flows into the power supply terminal 10 as a power supply current. Then, when the symptom diagnosis is performed by using the power supply current corresponding to the sum of the consumption currents of the main function circuit unit and the symptom diagnosis circuit unit, the symptom diagnosis can be performed both on the main function circuit unit 11 and the symptom diagnosis circuit.

[Second Embodiment]

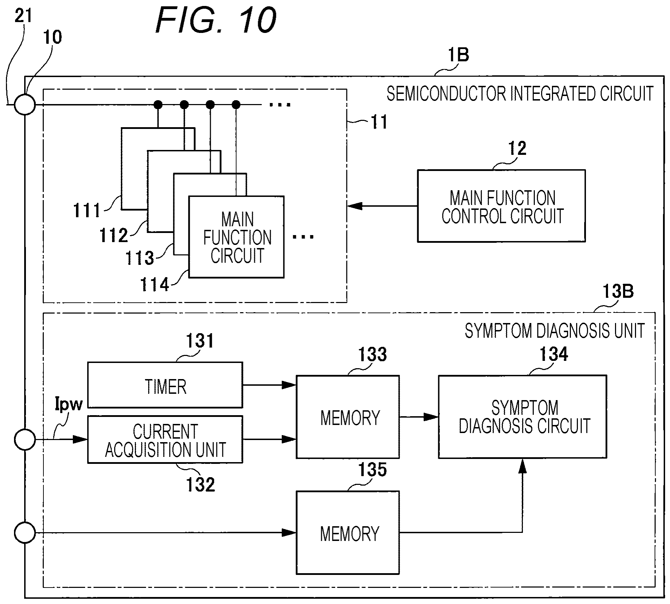

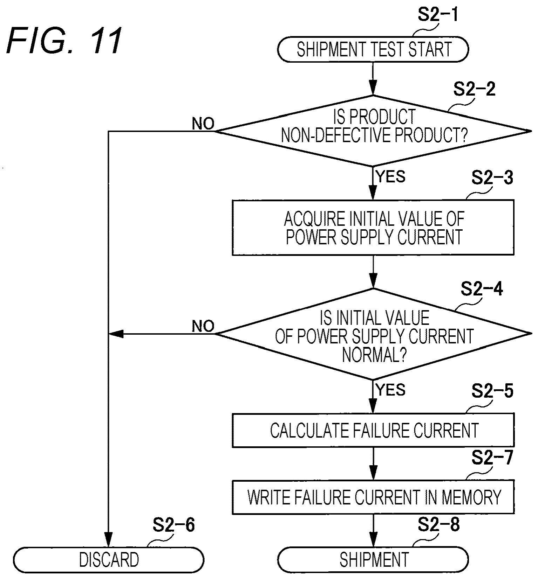

Next, a configuration example of a semiconductor integrated circuit and a symptom diagnosis method according to a second embodiment of the invention will be described with reference to FIGS. 10 and 11. In the second embodiment, in consideration of variation in a power supply current supplied from the power supply circuit to the semiconductor integrated circuit due to manufacturing variation of the ECU, the semiconductor integrated circuit acquires an initial value of the power supply current at the time when the ECU is manufactured. Note that although the manufacturing variation may occur in components other than the ECU, the manufacturing variation of the ECU is assumed in the second embodiment.

In the semiconductor integrated circuit according to the second embodiment, in addition to the functional units forming the semiconductor integrated circuit according to the first embodiment, the failure current is set in accordance with the initial value of the power supply current acquired by the semiconductor integrated circuit at the time when the ECU is manufactured. The configuration example of the semiconductor integrated circuit and the method of setting the initial value of the power supply current according to the second embodiment are implemented in order to perform symptom diagnosis with a symptom diagnosis threshold that takes into consideration the variation in the power supply current due to the manufacturing variation of the ECU. Differences from the first embodiment will be mainly described below.

<Configuration example of semiconductor integrated circuit according to second embodiment>

Here, as an example of the semiconductor integrated circuit according to the second embodiment of the invention, a configuration of a semiconductor integrated circuit 1B illustrated in FIG. 10 is conceivable.

FIG. 10 is a block diagram illustrating an internal configuration example of the semiconductor integrated circuit 1B according to the second embodiment.

The semiconductor integrated circuit 1B includes the main function circuit unit 11, the main function control circuit 12, and a symptom diagnosis unit 13B. The symptom diagnosis unit 13B includes a memory 135 in addition to the timer 131, the current acquisition unit 132, the memory 133, and the symptom diagnosis circuit 134.

When attention is paid to a difference between the semiconductor integrated circuit 1B according to the second embodiment and the semiconductor integrated circuit 1A according to the first embodiment illustrated in FIG. 2, the symptom diagnosis unit 13B of the semiconductor integrated circuit 1B includes the memory 135 directly connected to a terminal.

The memory 135 can rewrite data stored in the memory 135 in response to a signal input from an external apparatus (for example, a manufacturing apparatus) for the ECU 2. Therefore, the memory (memory 135) has, as an initial value, information on a consumption current acquired in the diagnosis mode at the time of the manufacturing process or shipment. For example, data of the failure current Ibreak is stored in the memory 135 at the time of a shipment test on the semiconductor integrated circuit 1B. Moreover, a symptom diagnosis threshold calculated on the basis of the initial value is set in the memory (memory 133).

The symptom diagnosis circuit 134 predicts the remaining life Trest_life on the basis of data of the failure current Ibreak stored in the memory 135. The method of predicting remaining life Trest_life is the same as the method described in the first embodiment, and thus description thereof will be omitted. Note that when the semiconductor integrated circuit 1B is actually used, the memories 133, 135 may be configured as one memory, and the respective data may be stored in different storage areas.

By configuring the semiconductor integrated circuit 1B as illustrated in FIG. 10, the manufacturing apparatus for the ECU 2 determines the failure current Ibreak on the basis of the initial value Iini acquired in the manufacturing process of the ECU 2. Then, the symptom diagnosis circuit 134 calculates the remaining life Trest_life by using the data of the failure current Ibreak, and compares the remaining life Trest_life with the symptom diagnosis threshold Tth_symptom to perform symptom diagnosis. In this manner, the symptom diagnosis circuit 134 can perform symptom diagnosis in consideration of manufacturing variation of the ECU 2 with respect to the power supply current for each semiconductor integrated circuit.

<Example of shipment test>

For the semiconductor integrated circuit 1B according to the second embodiment, the manufacturing apparatus acquires the initial value Iini of the power supply current in the shipment test in the manufacturing process. Then, the manufacturing apparatus calculates the failure current Ibreak, and writes data of the failure current Ibreak to the memory 135. Here, the shipment test in the manufacturing process will be described with reference to FIG. 11.

FIG. 11 is a flowchart illustrating an example of a shipment test of the semiconductor integrated circuit 1B.

In the manufacturing process in which the semiconductor integrated circuit 1B is mounted on the ECU, the manufacturing apparatus for the ECU starts the shipment test (S2-1), and the processing proceeds to S2-2. The processing S2-2 and later is performed by the manufacturing apparatus for the ECU.

In the normally performed shipment test, the manufacturing apparatus determines whether or not the semiconductor integrated circuit 1B is a non-defective product (S2-2). In a case where the manufacturing apparatus determines that the semiconductor integrated circuit 1B is a non-defective product (YES in S2-2), the processing proceeds to S2-3. On the other hand, in a case where the manufacturing apparatus determines that the semiconductor integrated circuit 1B is a defective product (NO in S2-2), the processing proceeds to S2-6. The semiconductor integrated circuit 1B determined as a defective product is discarded (S2-6). Thereafter, another semiconductor integrated circuit 1B is mounted on the ECU, and the shipment test is started again (S2-1).

After the YES determination in S2-2, the manufacturing apparatus acquires the initial value Iini of the power supply current under a predetermined test condition (S2-3), and the processing proceeds to S2-4. Next, the manufacturing apparatus determines whether or not the initial value Iini of the power supply current is normal (S2-4). The determination here is made on the basis of, for example, whether or not, with respect to two test thresholds Ith_test_h, Ith_test_1 for determining a non-defective product or a defective product, the initial value Iini of the power supply current is smaller than the test threshold Ith_test_h and equal to or larger than the test threshold Ith_test_1. ($Ith\_test\_1 \le Iini < Ith\_test\_h$)

In a case where the initial value Iini of the power supply current is smaller than the test threshold Ith_test_h and equal to or larger than the test threshold Ith_test_1, the manufacturing apparatus determines that the initial value Iini of the power supply current is normal (YES in S2-4). In this case, the manufacturing apparatus determines that the semiconductor integrated circuit 1B is a non-defective product, and the processing proceeds to S2-5. On the other hand, in a case where the initial value Iini of the power supply current is already equal to or larger than the test threshold Ith_test_h, or is already smaller than the test threshold Ith_test_l, the manufacturing apparatus determines that the initial value Iini of the power supply current is abnormal (NO in S2-4). In this case, the manufacturing apparatus determines that the semiconductor integrated circuit 1B is a defective product, and the processing proceeds to S2-6.

Next, the manufacturing apparatus calculates the failure current Ibreak on the basis of the acquired initial value Iini of the power supply current (S2-5), and the processing proceeds to S2-7.

Next, the manufacturing apparatus writes the failure current Ibreak to the memory 135 (S2-7), and the processing proceeds to S2-8. Thereafter, the semiconductor integrated circuit 1B is shipped as a non-defective product (S2-8).

In the semiconductor integrated circuit 1B according to the second embodiment described above, the failure current Ibreak calculated on the basis of the initial value Iini of the power supply current acquired by the manufacturing apparatus in the shipment test is set in the memory 135. Therefore, the symptom diagnosis unit 13B can perform symptom diagnosis on the semiconductor integrated circuit 1B by using the failure current Ibreak that is a determination threshold set in consideration of the variation in the power supply current Ipw, in response to the manufacturing variation of the ECU 2.

Note that in the second embodiment, the method of setting the failure current Ibreak in the memory 135 in accordance with the initial value Iini acquired by the manufacturing apparatus in the manufacturing process of the semiconductor integrated circuit 1B has been described. However, the device that writes the failure current may be the semiconductor integrated circuit 1B itself instead of the manufacturing apparatus. For example, a configuration is made in which the power supply current Ipw first acquired by the current acquisition unit 132 after shipment of the ECU 2 is set as the initial value Iini, and in which the failure current Ibreak in accordance with the initial value Iini is set inside the semiconductor integrated circuit 1B. With this configuration, a terminal via which information is written from the manufacturing apparatus to the memory 135 is unnecessary, and the number of terminals of the semiconductor integrated circuit 1B can be reduced. In this manner, the calculation of the failure current Ibreak is not limited to being performed by the manufacturing apparatus, and may be performed in the semiconductor integrated circuit 1B.

[Third Embodiment]

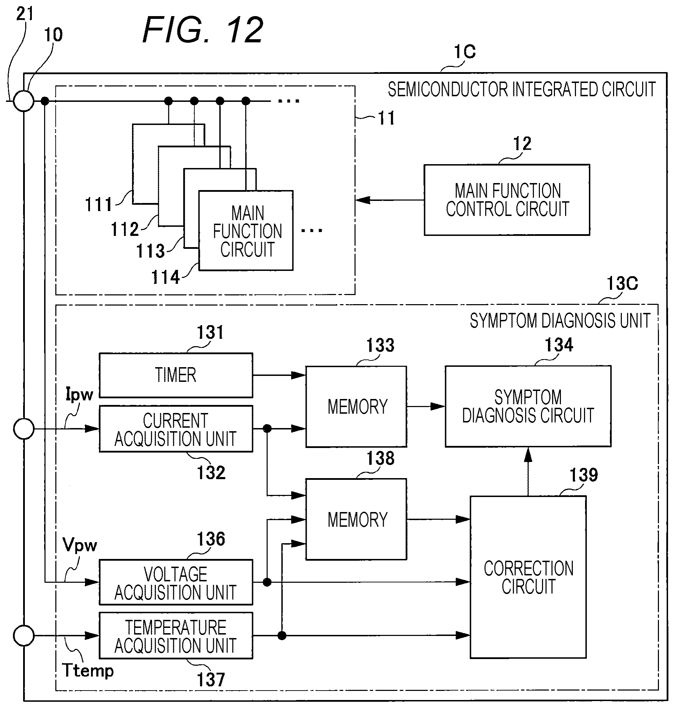

Next, a configuration example and an operation example of a semiconductor integrated circuit according to a third embodiment of the invention will be described with reference to FIG. 12.

In the semiconductor integrated circuit according to the third embodiment, in addition to the processing performed in the configuration of the first embodiment, the failure current or the approximate expression is corrected by acquiring a power supply voltage and a temperature of the semiconductor integrated circuit, and symptom diagnosis in consideration of a current value that is variable due to the influence of the power supply voltage and the temperature can be performed. Note that differences from the first embodiment will be mainly described below.

The semiconductor integrated circuit according to the third embodiment includes a voltage acquisition unit that acquires a power supply voltage of the semiconductor integrated circuit, a temperature acquisition unit that acquires a temperature in the semiconductor integrated circuit, and a correction circuit that corrects a failure current or an approximate expression in accordance with the power supply voltage or the temperature. As an example of the semiconductor integrated circuit according to the third embodiment, a configuration of a semiconductor integrated circuit 1C illustrated in FIG. 12 is conceivable.

<Configuration example of semiconductor integrated circuit according to third embodiment>

FIG. 12 is a block diagram illustrating a configuration example of the semiconductor integrated circuit 1C according to the third embodiment of the invention. Here, the configuration example of the semiconductor integrated circuit 1C, the semiconductor integrated circuit 1C, and a correction method of correcting the failure current or the approximate expression will be described. Note that the approximate expression to be corrected may be any of the expressions (1), (2) described above.

The semiconductor integrated circuit 1C includes the main function circuit unit 11, the main function control circuit 12, and a symptom diagnosis unit 13C. The symptom diagnosis unit 13C includes a voltage acquisition unit 136, a temperature acquisition unit 137, a memory 138, and a correction circuit 139, in addition to the timer 131, the current acquisition unit 132, the memory 133, and the symptom diagnosis circuit 134. The voltage acquisition unit 136, the temperature acquisition unit 137, the memory 138, and the correction circuit 139 are differences between the semiconductor integrated circuit 1A according to the first embodiment (see FIG. 2) and the semiconductor integrated circuit 1C according to the third embodiment.

The voltage information acquisition unit (voltage acquisition unit 136) acquires voltage information from a voltage detection unit that detects a power supply voltage of the power supply terminal (power supply terminal 10). For example, the voltage acquisition unit 136 acquires the power supply voltage Vpw. The input of the voltage acquisition unit 136 is connected to a power supply line, and acquires the voltage information on the power supply voltage at a timing at which the power supply current Ipw is acquired. The timing at which the power supply current Ipw is acquired is a timing at which the current acquisition unit 132 acquires the power supply current Ipw.

The temperature information acquisition unit (temperature acquisition unit 137) acquires temperature information from a temperature detection unit (temperature sensor) that detects a temperature inside the semiconductor integrated circuit (semiconductor integrated circuit 1C) or around the semiconductor integrated circuit (semiconductor integrated circuit 1C). The input of the temperature acquisition unit 137 is connected to a terminal, and a terminal end is connected to the output of the temperature detection unit (temperature sensor) installed inside or outside the semiconductor integrated circuit. The temperature sensor outputs temperature information that is a voltage proportional to a temperature, and the temperature acquisition unit 137 acquires a voltage Vtemp having the temperature information that is output from the temperature sensor and that is information at the timing at which the power supply current Ipw is acquired.

The memory 138 stores correction information in accordance with the power supply voltage Vpw and a temperature Vtemp. The correction information is information on power supply voltage dependency of the power supply current and information on temperature dependency of the power supply current. The memory 138 stores the power supply voltage Vpw, and the voltage Vsense_pw output by the current detection circuit 4 on the basis of the power supply current Ipw in association with each other, whereby the correction circuit 139 can recognize the voltage dependency of the power supply current Ipw. Similarly, the memory 138 stores the temperature Vtemp and the voltage Vsense_pw in association with each other, whereby the correction circuit 139 can recognize the temperature dependency of the power supply current Ipw.

The correction circuit 139 corrects the failure current Ibreak on the basis of the correction information in the memory 138, and outputs the corrected failure current Ibreak to the symptom diagnosis circuit 134. Thus, the correction circuit 139 receives two inputs of the power supply voltage Vpw acquired by the voltage acquisition unit 136, and the voltage Vtemp having the temperature information, acquired by the temperature acquisition unit 137, and corrects the failure current Ibreak by using the power supply voltage Vpw, the voltage Vtemp, and the correction information in the memory 138.

The symptom diagnosis circuit (symptom diagnosis circuit 134) predicts a failure occurrence timing of the circuit unit (main function circuit unit 11) by using a symptom diagnosis threshold or a consumption current corrected on the basis of the temperature information. In addition, the symptom diagnosis circuit (symptom diagnosis circuit 134) predicts a failure occurrence timing of the circuit unit (main function circuit unit 11) by using a symptom diagnosis threshold or a consumption current corrected on the basis of the voltage information.

<Example of operation of correcting failure current Ibreak>

Here, as an example of the operation of correcting the failure current or the approximate expression in the semiconductor integrated circuit 1C, an operation will be described in which the symptom diagnosis circuit 134 corrects the failure current Ibreak in accordance with the power supply voltage Vpw.

The voltage acquisition unit 136 acquires the power supply voltage Vpw at a timing at which the current acquisition unit 132 acquires the power supply current Ipw. The data of the power supply voltage Vpw acquired by the voltage acquisition unit 136 is stored in the memory 138.

The temperature acquisition unit 137 acquires the temperature Vtemp at the timing at which the current acquisition unit 132 acquires the power supply current Ipw. The data of the temperature Vtemp acquired by the temperature acquisition unit 137 is stored in the memory 138.

The correction circuit 139 corrects the failure current Ibreak, in accordance with the power supply voltage Vpw acquired by the voltage acquisition unit 136. In addition, the correction circuit 139 can also correct the failure current Ibreak, in accordance with the temperature Vtemp acquired by the temperature acquisition unit 137.

The symptom diagnosis circuit 134 calculates the remaining life Trest_life by using the corrected failure current Ibreak.

Note that as a method of correcting the failure current Ibreak in accordance with the power supply voltage Vpw, for example, a method of measuring the power supply voltage dependency at the time of product shipment inspection and storing correction information corresponding to the power supply voltage in the memory 138 can be considered. The operation of correcting symptom diagnosis in accordance with the temperature is the same as the operation of changing symptom diagnosis in accordance with the power supply voltage, and thus description of the operation will be omitted.

The correction circuit 139 compares the power supply voltage Vpw acquired at the same timing as the timing at which the power supply current Ipw is acquired with the correction information corresponding to the power supply voltage stored in the memory 138 to derive a correction value. Therefore, the correction circuit 139 corrects the failure current Ibreak, in accordance with the power supply voltage, whereby the symptom diagnosis circuit 134 can perform appropriate symptom diagnosis in accordance with the power supply voltage dependency of the power supply current Ipw. For example, a case will be described in which the power supply voltage dependency obtained at the time of product shipment inspection has a positive slope. In a case where the power supply voltage at the timing at which the power supply current Ipw is acquired is higher than expected, the power supply current Ipw is acquired with a value larger than expected, and thus the correction circuit 139 corrects the failure current Ibreak such that a difference from the initial value is larger than a set value. On the other hand, in a case where the power supply voltage at the timing at which the power supply current Ipw is acquired is lower than expected, the power supply current Ipw is acquired with a value smaller than expected, and thus the correction circuit 139 corrects the failure current Ibreak such that a difference from the initial value is smaller than the set value.

The semiconductor integrated circuit 1C according to the third embodiment described above corrects the failure current Ibreak used for symptom diagnosis, in accordance with the power supply voltage or the temperature. Therefore, when the power supply current changes due to the influence of the power supply voltage or the temperature, it is possible to prevent the symptom diagnosis circuit 134 from erroneously determining that the main function circuit unit 11 is in a state of a failure symptom.

Note that in the third embodiment, the method of correcting the failure current Ibreak by using the information both on the power supply voltage and the temperature has been described. However, the correction circuit 139 can correct the failure current Ibreak by using only one parameter of the power supply voltage or the temperature. For example, in a case where the configuration is a configuration in which the symptom diagnosis unit 13C includes simply the voltage acquisition unit 136, the correction circuit 139 may correct the failure current Ibreak by using only the information on the power supply voltage. In addition, in a case where the symptom diagnosis unit 13C includes simply the temperature acquisition unit 137, the correction circuit 139 may correct the failure current Ibreak by using only the information on the temperature.

[Fourth Embodiment]

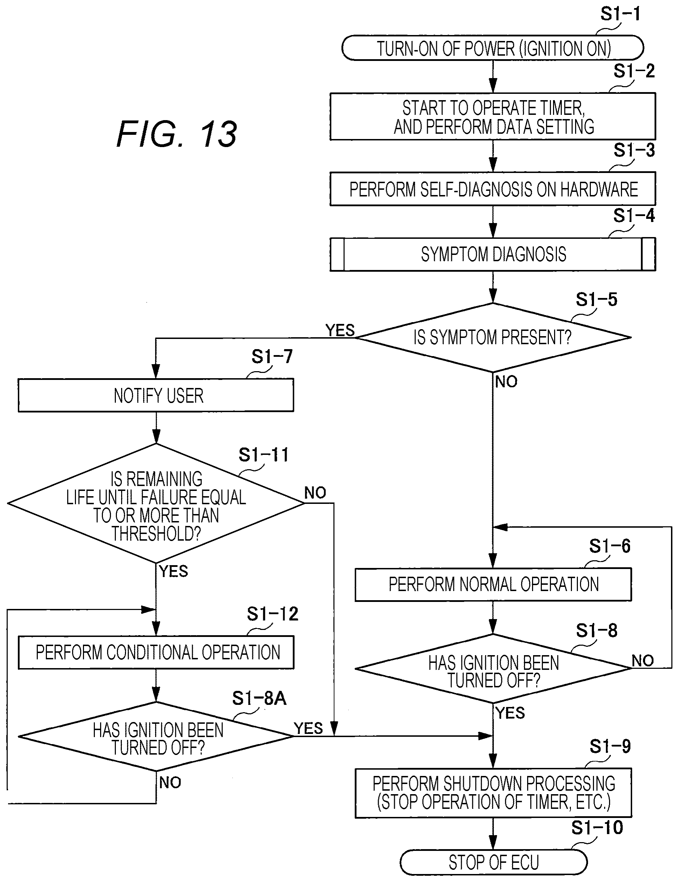

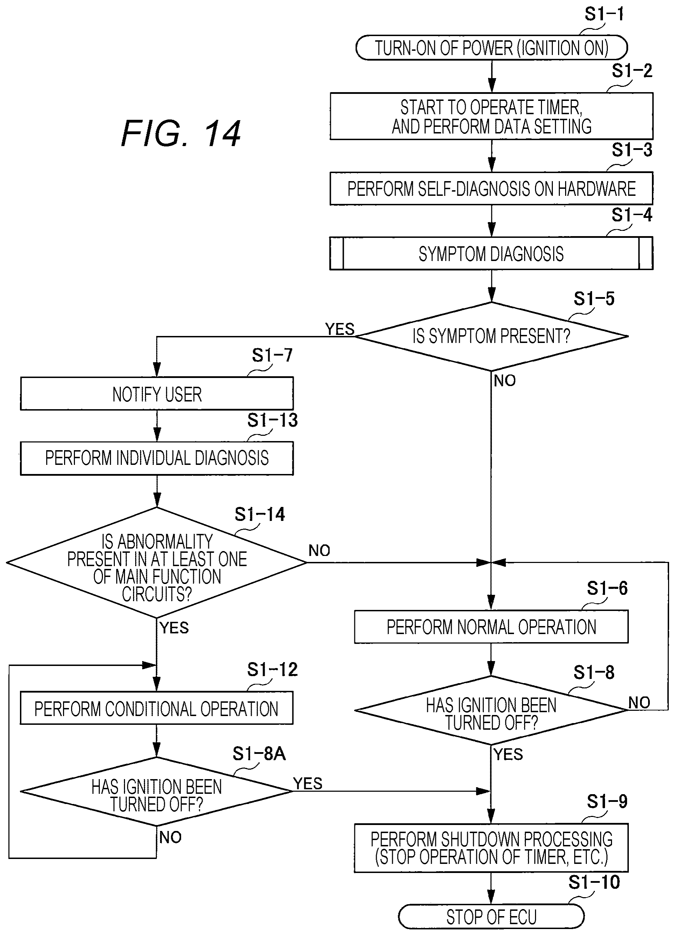

Next, a configuration example and an operation example of a semiconductor integrated circuit according to a fourth embodiment of the invention will be described with reference to FIGS. 13 and 14.

The semiconductor integrated circuit according to the fourth embodiment is a semiconductor integrated circuit with a configuration in which control in the semiconductor integrated circuit is changed after it is diagnosed that a failure symptom is present in the symptom diagnosis, in addition to the processing performed with the configuration in the first embodiment. With the semiconductor integrated circuit according to the fourth embodiment, it is possible to perform desired control before an abnormality occurs in the semiconductor integrated circuit, such as safety control such as functional limitation, or control for identifying a symptom-diagnosed portion through individual diagnosis. Note that differences from the semiconductor integrated circuit described in the first embodiment will be mainly described below. In addition, the configuration of the semiconductor integrated circuit according to the fourth embodiment is the same as the configuration of the semiconductor integrated circuit according to the first embodiment illustrated in FIG. 2, and thus detailed description thereof will be omitted.

<Example of processing of changing traveling control after symptom diagnosis>

FIG. 13 is a flowchart illustrating an example of processing in which the semiconductor integrated circuit according to the fourth embodiment changes traveling control after symptom diagnosis. Here, it is assumed that the semiconductor integrated circuit 1A illustrated in FIG. 2 performs change processing on the traveling control according to the fifth embodiment.

In a case where it is diagnosed that a symptom is present in the symptom diagnosis, processing is performed in which functional limitation such as control of torque of the vehicle and limitation on a rotation speed of the vehicle is performed. A vehicle control unit (not illustrated) is allowed to limit the vehicle speed by limiting the torque and the rotation speed of the vehicle, and it is possible to perform traveling control safer than control during the normal operation of the semiconductor integrated circuit 1A. Note that description of the same flow as the flow described above will be omitted, and differences will be mainly described.

The processing from S1-1 to S1-5 is similar to the processing illustrated in FIG. 3. The processing after the NO determination in S1-5 is similar to S1-6 to S1-10 illustrated in FIG. 3.

After the YES determination in S1-5, the symptom diagnosis circuit 134 notifies the user of the presence of a symptom by performing control such as turning on the in-vehicle warning light (S1-7), and the processing proceeds to S1-11.

Next, the symptom diagnosis circuit 134 determines whether or not the remaining life Trest_life until failure is equal to or longer than an operation capability determination threshold Tth_ope (S1-11). The remaining life Trest_life is determined by the symptom diagnosis circuit 134 comparing the remaining life Trest_life with the operation capability determination threshold Tth_ope.

In a case where the remaining life Trest_life is equal to or longer than the operation capability determination threshold Tth_ope (YES in S1-11), the symptom diagnosis circuit 134 determines that the remaining life Trest_life has a sufficient remaining life, and the processing proceeds to S1-12. On the other hand, in a case where the remaining life Trest_life is shorter than the operation capability determination threshold Tth_ope (NO in S1-11), the symptom diagnosis circuit 134 determines that the remaining life Trest_life is short and an urgent action is necessary, and the processing proceeds to S1-9.

After the YES determination in S1-11, the semiconductor integrated circuit 1A performs a conditional operation according to the fourth embodiment (S1-12). The conditional operation is, for example, an operation in which the vehicle control unit (not illustrated) provided in the ECU 2 limits the torque and the rotation speed of the vehicle. After the symptom diagnosis circuit (symptom diagnosis circuit 134) has diagnosed that a failure symptom is present, there is performed at least one of control in which the function of the circuit unit (main function circuit unit 11) is limited, control in which the torque of the vehicle is limited, control in which the circuit unit (main function circuit unit 11) is operated except for a portion where the failure symptom has been detected, or control in which the maximum operation of the system including the semiconductor integrated circuit (semiconductor integrated circuit 1A) is not performed. While the conditional operation is performed, the semiconductor integrated circuit 1A periodically monitors the power supply voltage Vpw.

Next, the semiconductor integrated circuit 1A determines whether or not the ignition has been turned off (S1-8A). Similarly to S1-8 in FIG. 3, the semiconductor integrated circuit 1A determines whether or not the ignition has been turned off by comparing the power supply voltage Vpw with the low voltage threshold Vmin_ope. In a case where the power supply voltage Vpw is equal to or higher than the low voltage threshold Vmin_ope, the semiconductor integrated circuit 1A determines that the ignition has not been turned off (NO in S1-8A), and the processing proceeds to S1-12, continuing the conditional operation. On the other hand, in a case where the power supply voltage Vpw is lower than the low voltage threshold Vmin_ope (YES in S1-8A), the semiconductor integrated circuit 1A determines that the ignition has been turned off, and stops the normal operation such as generation of the load drive signal or the load driving, and the processing proceeds to S1-9.

As described above, the flowchart illustrated in FIG. 13 shows the processing of changing the traveling control after the presence of a symptom is diagnosed in the symptom diagnosis. As the change in the traveling control, for example, the processing in which the vehicle control unit limits the torque or the rotation speed of the vehicle is assumed, and the vehicle speed is limited by this change. Thus, the traveling control safer than the control during the normal operation of the semiconductor integrated circuit 1A is performed.

<Processing of adding individual diagnosis to symptom diagnosis processing>

In the symptom diagnosis processing according to the fourth embodiment illustrated in FIG. 13, the description has been made for the control of performing the minimum operation necessary for traveling in order to reduce the influence of the variation in characteristics over time in a case where a symptom is present and the remaining life Trest_life is equal to or longer than the operation capability determination threshold Tth_ope. However, the symptom diagnosis circuit 134 may perform an operation of identifying a symptom-diagnosed portion by performing, after the symptom diagnosis, individual diagnosis through which a specific abnormality can be detected.

<Example of processing for identifying main function circuit having symptom after symptom diagnosis>

FIG. 14 is a flowchart illustrating an example of processing for identifying a main function circuit having a symptom after the symptom diagnosis circuit 134 performs symptom diagnosis. Note that description of the same processing as the processing in the flowchart illustrated in FIG. 13 will be omitted, and differences between the processing in FIG. 13 and the processing in FIG. 14 will be mainly described.

After the YES determination in S1-5, the symptom diagnosis unit 13 notifies the user of the vehicle of information indicating that a failure symptom is present in the main function circuit unit 11 through an in-vehicle warning light or the like (S1-7), and the processing proceeds to S1-13.

Next, as the individual diagnosis according to the fourth embodiment, each of respective functional diagnoses on the main function circuits 111 to 114 mounted on the main function circuit unit 11 is performed (S1-13), and the processing proceeds to S1-14. Note that the main function circuits 111 to 114 themselves can detect their own functional abnormalities. Then, the main function control circuit 12 can acquire a result of the functional diagnosis for each of the main function circuits 111 to 114.

Next, the main function control circuit 12 determines whether or not a functional abnormality is present in at least one of the main function circuits 111 to 114, on the basis of the result of the functional diagnosis performed by each of the main function circuits 111 to 114 mounted on the main function circuit unit 11 (S1-14). Note that in S1-14, the symptom diagnosis unit 13 does not perform symptom diagnosis, and presence or absence of a functional abnormality in each of the main function circuits 111 to 114 is diagnosed on the basis of whether or not a voltage abnormality, a clock abnormality, or the like has been detected by using an existing technique.

In a case where no functional abnormality has been detected in all the main function circuits 111 to 114 (NO in S1-14), the main function circuit unit 11 determines that the main function circuits 111 to 114 do not fail, and the processing proceeds to S1-6. In S1-6, the normal operation is performed.

On the other hand, in a case where a functional abnormality has been detected in at least one of the main function circuits 111 to 114 (YES in S1-14), there is a concern about failure due to deterioration. Therefore, the main function control circuit 12 causes any of the main function circuits 111 to 114 in which a functional abnormality has been detected to be operated with the conditional operation (S1-12), and the processing proceeds to S1-8A.

In the processing illustrated in the flowchart of FIG. 14, after the symptom diagnosis unit 13 performs symptom diagnosis (S1-4), each of the main function circuits 111 to 114 performs individual diagnosis (S1-13) through which its own specific functional abnormality can be detected. Therefore, the main function control circuit 12 can identify a symptom-diagnosed portion on the basis of the detection results of the functional abnormalities of the plurality of main function circuits 111 to 114.

The semiconductor integrated circuit 1A according to the fourth embodiment described above has a configuration in which the control in the semiconductor integrated circuit 1A including the main function circuit in which the functional abnormality is detected is changed after it is diagnosed that a symptom is present in the symptom diagnosis. Therefore, even in a case where a functional abnormality has occurred in any of the main function circuits 111 to 114, the main function control circuit 12 can perform desired control for the main function circuit unit 11, such as safety control such as functional limitation, or control for identifying a symptom-diagnosed portion through individual diagnosis.

In addition, since any of the main function circuits 111 to 114 in which the functional abnormality has occurred is subjected to the functional limitation, the temperature of the main function circuit subjected to the functional limitation can be reduced. Therefore, the remaining life of the main function circuit unit 11 including the main function circuit subjected to the functional limitation can also be extended.

Note that, in the semiconductor integrated circuit 1A according to the fourth embodiment, in addition to the operation of performing the control under the functional limitation, the torque limitation, or the individual diagnosis, control may be performed in which the variation over time in characteristics of the semiconductor integrated circuit 1A is reduced. In addition, control may be performed in which after a circuit in which a symptom has been detected in the individual diagnosis is identified, portions other than the portion where the symptom has been detected are operated, or control may be performed in which the maximum operation of a vehicle control system including the ECU 2 is not performed. Further, a plurality of controls after symptom diagnosis may be used in combination.

[Fifth Embodiment]

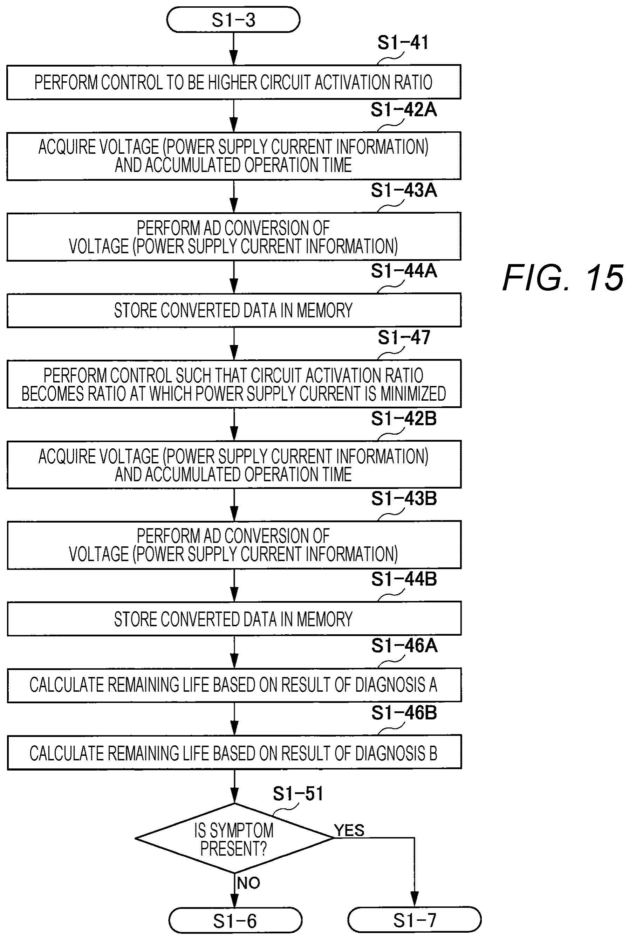

Next, an example of a symptom diagnosis method for a semiconductor integrated circuit according to a fifth embodiment of the invention will be described with reference to FIG. 15.

In the semiconductor integrated circuit according to the fifth embodiment, the main function circuit unit is divided into several block units (for example, per main function circuit) and diagnosed, whereby the power supply currents in a plurality of circuit operations can be individually acquired during symptom diagnosis as compared with the first embodiment. Differences from the semiconductor integrated circuit described in the first embodiment will be mainly described below. In addition, the configuration of the semiconductor integrated circuit 1A is the same as the configuration illustrated in FIG. 2, and thus description thereof will be omitted.

As an example of the symptom diagnosis flow according to the fifth embodiment, there is a diagnosis flow in which there are performed, in turn, a plurality of symptom diagnoses of a diagnosis A in which diagnosis is performed at a circuit activation ratio higher than the circuit activation ratio during the normal operation and a diagnosis B in which diagnosis is performed at a circuit activation ratio at which the power supply current is minimized.

<Method of diagnosing semiconductor integrated circuit according to fifth embodiment>

FIG. 15 is a flowchart illustrating an example of processing performed by the symptom diagnosis unit of the semiconductor integrated circuit according to the fifth embodiment of the invention. Here, it is assumed that the semiconductor integrated circuit 1A illustrated in FIG. 2 performs the method of diagnosing the semiconductor integrated circuit according to the fifth embodiment. In addition, the main function circuit unit 11 classifies the main function circuits 111 to 114 for each of functions performed by the main function circuits 111 to 114, and divides the main function circuits 111 to 114 into block units in accordance with the functions. The block unit is, for example, a unit in which some main function circuits are collected. The block units can be freely changed, such as one main function circuit per block unit or two main function circuits per block unit. Then, the symptom diagnosis unit 13 performs symptom diagnosis in a plurality of modes (diagnoses A, B) in which an operation state of the circuit unit (main function circuit unit 11) varies in block units. Note that description of the same flow as the flow described with reference to FIG. 4 will be omitted, and differences will be mainly described.

(Processing of diagnosis A)

In the diagnosis A, as described above, control is performed to be in a state where the circuit activation ratio of the main function circuit unit 11 is high (S1-41). Next, processing in which the current acquisition unit 132 acquires a voltage Vsense_pw_A having the power supply current information from the current detection circuit 4, and processing in which the timer 131 acquires accumulated operation time data Dt_A are simultaneously performed (S1-42A), and the processing proceeds to S1-43A.

Next, the current acquisition unit 132 performs AD conversion of the acquired voltage Vsense_pw_A into current data Di_A storable in the memory 133 (S1-43A), and the processing proceeds to S1-44A. Then, the current acquisition unit 132 and the timer 131 respectively store the power supply current data Di_A after the AD conversion and the accumulated operation time data Dt_A in the memory 133 in association with each other (S1-44A), and the processing proceeds to S1-47, and the processing of the diagnosis B is started.

(Processing of diagnosis B)

In the diagnosis B, the main function control circuit 12 performs control such that the circuit activation ratio becomes a circuit activation ratio at which the power supply current in the normal mode is minimized (S1-47), and the processing proceeds to S1-42B. In the diagnosis B, the number of operating main function circuit units is the minimum. Therefore, in at least one of the diagnosis modes, the circuit unit (main function circuit unit 11) operates with a consumption current smaller than a consumption current consumed in the circuit unit (main function circuit unit 11) operating normally.

Next, processing in which the current acquisition unit 132 acquires a voltage Vsense_pw_B having the power supply current information from the current detection circuit 4, and processing in which the timer 131 acquires accumulated operation time data Dt_B are simultaneously performed (S1-42B), and the processing proceeds to S1-43B.

Next, the current acquisition unit 132 performs AD conversion of the acquired voltage Vsense_pw_B into current data Di_B storable in the memory 133 (S1-43B), and the processing proceeds to S1-44B. Then, the current acquisition unit 132 and the timer 131 respectively store the power supply current data Di_B after the AD conversion and the accumulated operation time data Dt_B in the memory 133 in association with each other (S1-44B), and the processing proceeds to S1-46A.

Next, the symptom diagnosis circuit 134 calculates a remaining life Trest_lifeA until the current reaches a failure current IBreak_A, on the basis of time-series data (Dt_colA, Di_colA) that is the result of the diagnosis A stored in the memory 133 (S1-46A), and the processing proceeds to S1-46B.

Next, the symptom diagnosis circuit 134 calculates a remaining life Trest_lifeB until the current reaches a failure current IBreak_B, on the basis of time-series data (Dt_colB, Di_colB) that is the result of the diagnosis B stored in the memory 133 (S1-46B), and the processing proceeds to S1-51.

Next, the symptom diagnosis circuit 134 determines whether or not there is a symptom of presence of failure in the main function circuit unit 11 (S1-51). Here, the symptom diagnosis circuit (symptom diagnosis circuit 134) performs symptom diagnosis on the basis of time-series data acquired for each of the plurality of diagnosis modes from the circuit unit (main function circuit unit 11) operating in the plurality of diagnosis modes. For example, the symptom diagnosis unit 13 performs the symptom diagnosis by comparing the remaining lives Trest_lifeA and Trest_lifeB with the symptom diagnosis threshold Tth_symptom. Then, in a case where either the remaining life Trest_lifeA or Trest_lifeB is shorter than the symptom diagnosis threshold Tth_symptom, it is diagnosed that a symptom is present (YES in S1-51), and the processing proceeds to S1-7 in FIG. 3. On the other hand, in a case where both the remaining lives Trest_lifeA and Trest_lifeB are equal to or longer than the symptom diagnosis threshold Tth_symptom, it is diagnosed that there is no symptom (NO in S1-51), and the processing proceeds to S1-6.

In the semiconductor integrated circuit 1A according to the fifth embodiment described above, it is possible to acquire the power supply current in each of a plurality of circuit operations during the symptom diagnosis, and it is possible to diagnose the internal circuits by dividing the internal circuits into several block units. Here, in the symptom diagnosis according to the fifth embodiment, the symptom diagnosis unit 13 performs the two symptom diagnoses of the diagnosis A and the diagnosis B. Therefore, the time-series data (Dt_colA, Di_colA) obtained in the diagnosis A and the time-series data (Dt_colB, Di_colB) obtained in the diagnosis B are stored in the memory 133. Then, the symptom diagnosis circuit 134 can calculate each of the remaining lives Trest_lifeA and Trest_lifeB for a corresponding one of the time-series data of the diagnosis A and the time-series data of the diagnosis B read from the memory 133, and can perform the symptom diagnosis for each block on the basis of a corresponding one of the remaining lives Trest_lifeA and Trest_lifeB thereof.

In addition, in the diagnosis A in the symptom diagnosis according to the fifth embodiment, the circuit activation ratio of the main function circuit unit 11 to be subjected to the symptom diagnosis is made higher than that during the normal operation. Further, as for the individual diagnosis for each of the main function circuits 111 to 114 as in the diagnosis B, the circuit activation ratio is made lower than that during the normal operation. For example, in a deterioration mode in which a change in the power supply current is minute, if the power supply current is too large with respect to an amount of decreasing current, it is difficult to detect a change with the variation in characteristics over time. Therefore, the symptom diagnosis circuit 134 can perform the symptom diagnosis on the basis of the power supply current with which the circuit current is minimized as shown in the diagnosis B.

Note that the symptom diagnosis circuit 134 may perform the symptom diagnosis by combining the time-series data obtained in the diagnosis A and the time-series data obtained in the diagnosis B. In addition, in the fifth embodiment, an example of processing has been described in which the two symptom diagnoses are performed in turn. However, for the purpose of shortening the symptom diagnosis time, the symptom diagnosis unit 13 may perform, while performing AD conversion on one data, processing of acquiring the other data in parallel.

In addition, in the fifth embodiment, a method has been described in which classification is performed for each of the functions performed by the main function circuits 111 to 114, and in which symptom diagnosis is performed for each classified one or more of the main function circuits 111 to 114. However, as long as the sum of all the circuit activation ratios in the plurality of diagnoses is higher than the circuit activation ratio during the normal operation, the classification of the diagnosis targets may be freely set. For example, the diagnosis A is diagnosis for comprehensively diagnosing the main function circuit unit 11 at a circuit activation ratio higher than the circuit activation ratio during the normal operation, and the diagnosis B is diagnosis for individually diagnosing any of the main function circuits 111 to 114 at a circuit activation ratio lower than the circuit activation ratio during the normal operation. In this case, any of the main function circuits 111 to 114 to be diagnosed may be diagnosed duplicately in the plurality of diagnoses A, B.

[Sixth Embodiment]

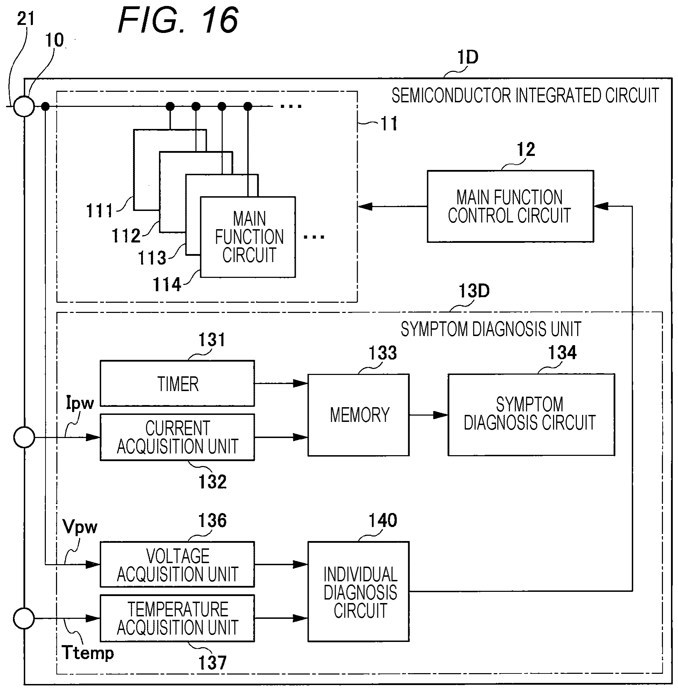

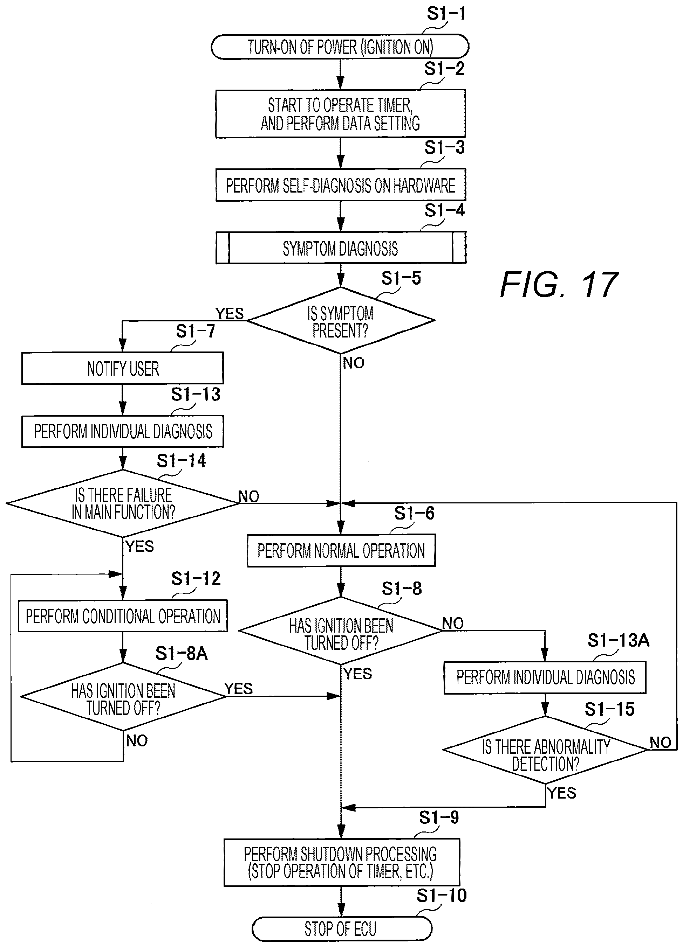

Next, a configuration example of a semiconductor integrated circuit and an example of a symptom diagnosis method according to a sixth embodiment of the invention will be described with reference to FIGS. 16 and 17.

In the semiconductor integrated circuit according to the sixth embodiment, symptom diagnosis is performed at the time of activation, and individual diagnosis is performed during the normal operation, whereby an unexpected abnormality due to accidental failure such as component disengagement due to vibration is detected through the individual diagnosis. Therefore, in the semiconductor integrated circuit according to the sixth embodiment, continuous deterioration due to wear failure such as electromigration can be detected through symptom diagnosis. Note that differences from the semiconductor integrated circuit described in the first embodiment will be mainly described below.

<Configuration example of semiconductor integrated circuit according to sixth embodiment>

FIG. 16 is a block diagram illustrating a configuration example of a semiconductor integrated circuit 1D according to the sixth embodiment of the invention. Here, a configuration example of the semiconductor integrated circuit 1D and an individual diagnosis method will be described.

The semiconductor integrated circuit 1D includes the main function circuit unit 11, the main function control circuit 12, and a symptom diagnosis unit 13D. The symptom diagnosis unit 13D includes the voltage acquisition unit 136, the temperature acquisition unit 137, and an individual diagnosis circuit 140, in addition to the timer 131, the current acquisition unit 132, the memory 133, and the symptom diagnosis circuit 134. The voltage acquisition unit 136, the temperature acquisition unit 137, and the individual diagnosis circuit 140 are differences between the semiconductor integrated circuit 1A according to the first embodiment (see FIG. 2) and the semiconductor integrated circuit 1D according to the sixth embodiment.

Configuration examples and operation examples of the voltage acquisition unit 136 and the temperature acquisition unit 137 are similar to the respective functional units included in the symptom diagnosis unit 13C according to the third embodiment illustrated in FIG. 12, and thus description thereof will be omitted.

The abnormality diagnosis unit (individual diagnosis circuit 140) diagnoses an abnormality in some of circuits, on the basis of information acquired from the circuit unit (main function circuit unit 11). Then, after the symptom diagnosis circuit (symptom diagnosis circuit 134) has diagnosed that a failure symptom is present, the abnormality diagnosis unit (individual diagnosis circuit 140) diagnoses an abnormality for a circuit in which the abnormality has been detected. For example, the individual diagnosis circuit 140 performs functional diagnosis on each of the main function circuits 111 to 114, and outputs an indication of "abnormality is present" in a case where a functional abnormality is present in any of the main function circuits. On the other hand, the individual diagnosis circuit 140 outputs an indication of "no abnormality" in a case where there is no functional abnormality in all the main function circuits 111 to 114. Note that the abnormality diagnosis unit (individual diagnosis circuit 140) may diagnose a failure symptom in the circuit unit (main function circuit unit 11) on the basis of the time-series data of the consumption current and the accumulated operation time, in addition to detection of an abnormality for each semiconductor integrated circuit including some of the circuits for which the abnormality has been diagnosed.

In the semiconductor integrated circuit 1D illustrated in FIG. 16, a type of diagnosis is changed in accordance with the operation of the semiconductor integrated circuit 1D. For example, the symptom diagnosis unit 13D performs symptom diagnosis at the time of activation of the semiconductor integrated circuit 1D, and performs individual diagnosis during the normal operation. Therefore, the individual diagnosis circuit 140 of the symptom diagnosis unit 13D can detect an unexpected abnormality due to accidental failure such as component disengagement due to vibration through individual diagnosis, for example. On the other hand, the symptom diagnosis circuit 134 can detect continuous deterioration due to wear failure such as electromigration through symptom diagnosis.

<Example of symptom diagnosis and individual diagnosis>

FIG. 17 is a flowchart illustrating an example of processing in which the symptom diagnosis unit 13D of the semiconductor integrated circuit 1D according to the sixth embodiment performs symptom diagnosis and individual diagnosis. The semiconductor integrated circuit 1D performs symptom diagnosis at the time of activation of the semiconductor integrated circuit, and performs individual diagnosis periodically during the normal operation. Note that description of the same processing as the processing described with reference to FIG. 14 will be omitted, and differences will be mainly described.

When the semiconductor integrated circuit 1D performs the normal operation in S1-6, the semiconductor integrated circuit 1D determines whether or not the ignition has been turned off in S1-8. In a case where the semiconductor integrated circuit 1D determines that the ignition has not been turned OFF because the power supply voltage Vpw is equal to or higher than the low voltage threshold Vmin_ope (NO in S1-8), the processing proceeds to S1-13A. On the other hand, in a case where the semiconductor integrated circuit 1D determines that the ignition has been turned off because the power supply voltage Vpw is lower than the low voltage threshold Vmin_ope (YES in S1-8), the semiconductor integrated circuit 1D stops the normal operation such as load driving, and the processing proceeds to S1-9.

After the NO determination in S1-8, the individual diagnosis circuit 140 performs functional diagnosis on each of the main function circuits 111 to 114 mounted on the main function circuit unit 11 (S1-13A), and the processing proceeds to S1-15.

The main function control circuit 12 acquires the result of the individual diagnosis of S1-13A from the individual diagnosis circuit 140, and determines whether or not an abnormality has been detected in the main function circuit unit 11 (S1-15). In a case where a functional abnormality is present in any of the main function circuits 111 to 114, the main function control circuit 12 determines that an abnormality is present in the main function circuit unit 11 (YES in S1-15), and the processing proceeds to S1-9. On the other hand, in a case where there is no functional abnormality in all the main function circuits 111 to 114, the main function control circuit 12 determines that there is no abnormality in the main function circuit unit 11 (NO in S1-15), and the processing proceeds to S1-6.

In the semiconductor integrated circuit 1D according to the sixth embodiment described above, the symptom diagnosis circuit 134 performs symptom diagnosis at the time of activation of the semiconductor integrated circuit 1D, and the individual diagnosis circuit 140 performs individual diagnosis during the normal operation. Therefore, in the semiconductor integrated circuit 1D, an unexpected abnormality due to accidental failure such as component disengagement due to vibration can be detected through individual diagnosis, and continuous deterioration due to wear failure such as electromigration can be detected through symptom diagnosis.

[Seventh Embodiment]

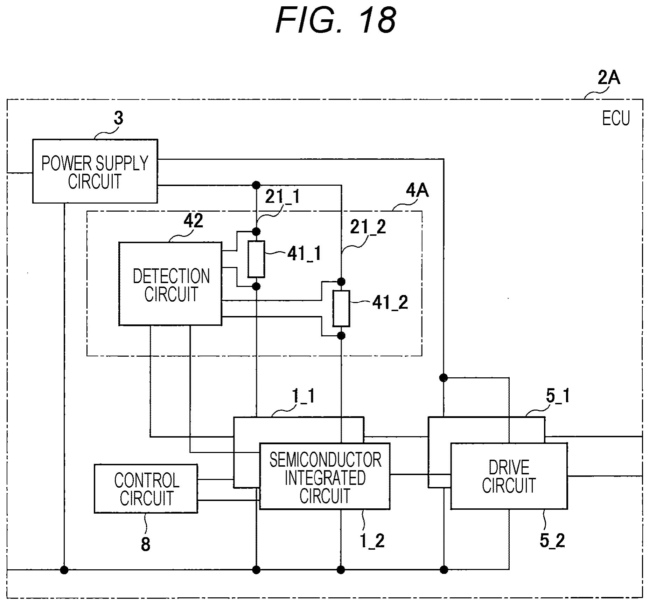

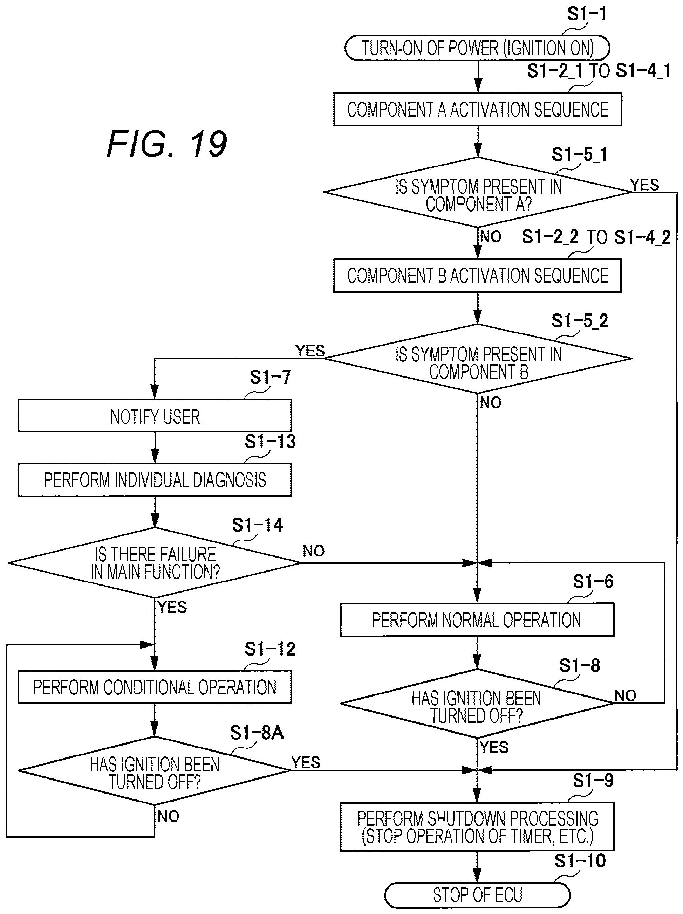

Next, a configuration example of an ECU and an example of diagnosis processing performed in each semiconductor integrated circuit, according to a seventh embodiment of the invention will be described with reference to FIGS. 18 and 19.

The ECU according to the seventh embodiment includes a plurality of semiconductor integrated circuits and a control circuit that individually controls the plurality of semiconductor integrated circuits. Then, a current detection circuit connected to each power supply line branched for a corresponding one of the semiconductor integrated circuits outputs a power supply current as a voltage for each of the semiconductor integrated circuits, thereby enabling symptom diagnosis individually for each of the semiconductor integrated circuits. Here, the configuration and operation of an ECU 2A that can change system control in accordance with a priority order for the semiconductor integrated circuits for any of which the presence of a symptom has been diagnosed will be described. Note that differences from the semiconductor integrated circuit described in the first embodiment will be mainly described below.

<Configuration example of semiconductor integrated circuits according to seventh embodiment>

FIG. 18 is a block diagram illustrating an internal configuration example of the ECU 2A, according to the seventh embodiment of the invention, on which semiconductor integrated circuits 1_1, 1_2 according to the seventh embodiment of the invention are mounted.

The ECU 2A includes the power supply circuit 3, a current detection circuit 4A, the semiconductor integrated circuits 1_1, 1_2, drive circuits 5_1, 5_2, and a control circuit 8. The current detection circuit 4A, the semiconductor integrated circuits 1_1, 1_2, the drive circuits 5_1, 5_2, and the control circuit 8 are differences between the ECU 2 according to the first embodiment (see FIG. 1) and the ECU 2A according to the sixth embodiment.

Power supply lines 21_1, 21_2 through which power is supplied from the power supply circuit 3 to the semiconductor integrated circuits 1_1, 1_2 are connected to the current detection circuit 4A.

A resistor 41_1 is connected to the power supply line 21_1 between the power supply circuit 3 and the semiconductor integrated circuit 1_1. The resistor 41_1 detects a power supply current Ipw_1 supplied to the semiconductor integrated circuit 1_1. A resistor 41_2 is connected to the power supply line 21_2 between the power supply circuit 3 and the semiconductor integrated circuit 1_2. The resistor 41_2 detects a power supply current Ipw_2 supplied to the semiconductor integrated circuit 1_2. The resistors 41_1, 41_2 output the power supply currents Ipw_1, Ipw_2 detected from the power supply lines 21_1, 21_2 to the detection circuit 42 as voltages.

The detection circuit 42 detects a voltage generated across each of the resistors 41_1, 41_2, and outputs the voltages to the semiconductor integrated circuits 1_1, 1_2.

Each of the semiconductor integrated circuits 1_1, 1_2 is an example of a circuit in which a plurality of semiconductors are integrated. Each of the semiconductor integrated circuits 1_1, 1_2 has the same configuration as the configuration of the semiconductor integrated circuit 1A illustrated in FIG. 2. The semiconductor integrated circuit 1_1 outputs a drive command to the drive circuit 5_1. The drive circuit 5_1 outputs a drive signal to the load 6 (not illustrated in FIG. 18) illustrated in FIG. 1 on the basis of the drive command input from the semiconductor integrated circuit 1_1. The semiconductor integrated circuit 1_2 outputs a drive command to the drive circuit 5_2. The drive circuit 5_2 outputs a drive signal to the load 6 illustrated in FIG. 1 on the basis of the drive command input from the semiconductor integrated circuit 1_2.

The control circuit 8 individually controls the semiconductor integrated circuits 1_1, 1_2 in accordance with any of symptom diagnosis results for which the respective symptom diagnoses have been performed in the semiconductor integrated circuits 1_1, 1_2. Then, the control circuit 8 performs control in accordance with the order on the basis of which the symptom diagnosis is performed on the semiconductor integrated circuit 1_1 and the semiconductor integrated circuit 1_2. In addition, the control circuit 8 performs control in accordance with the priority order for the semiconductor integrated circuits 1_1, 1_2, in a case where the diagnosis of the presence of a symptom is performed on the semiconductor integrated circuit 1_1 or the semiconductor integrated circuit 1_2. Therefore, after the symptom diagnosis circuit (symptom diagnosis circuit 134) has diagnosed that a failure symptom is present, control on the semiconductor integrated circuits (semiconductor integrated circuits 1_1, 1_2) or a system including the semiconductor integrated circuits (semiconductor integrated circuits 1_1, 1_2) is changed.

According to the configuration illustrated in FIG. 18, the respective power supply currents of the semiconductor integrated circuit 1_1 and the semiconductor integrated circuit 1_2 are separated from each other, and thus symptom diagnosis can be performed individually. In addition, the control circuit 8 can change the system control in accordance with the priority order for the semiconductor integrated circuits 1_1, 1_2 for any of which the presence of a symptom has been diagnosed. For example, by performing control such as limiting the function of a semiconductor integrated circuit diagnosed as having the presence of a symptom preferentially, the control circuit 8 can reduce a load on the semiconductor integrated circuit diagnosed as having the presence of the symptom.

<Example of symptom diagnosis processing>

Next, an example of symptom diagnosis performed in the ECU 2A in a case where the semiconductor integrated circuits 1_1, 1_2 are respectively responsible for control related to traveling and control related to comfort will be described.

FIG. 19 is a flowchart illustrating an example of symptom diagnosis performed in the ECU 2A. Note that description of the same flow as the flow described above will be omitted, and differences will be mainly described. In FIG. 19, the semiconductor integrated circuit 1_1 may also be referred to as a component A, and the semiconductor integrated circuit 1_2 may also be referred to as a component B.

An activation sequence for the component A in S1-2_1 to S1-4_1 is the same flow as that of the processing in S1-2 to S1-4 illustrated in FIG. 3, and thus the description thereof will be omitted. After the activation sequence for the component A in S1-2_1 to S1-4_1, the symptom diagnosis unit 13 (symptom diagnosis circuit 134) of the semiconductor integrated circuit 1_1 determines whether or not a symptom is present in the component A (S1-5_1).

In a case where a remaining life Trest_life_1 of the semiconductor integrated circuit 1_1 is shorter than a symptom diagnosis threshold Vth_symptom_1, the symptom diagnosis unit 13 of the semiconductor integrated circuit 1_1 diagnoses that a symptom is present (YES in S1-5_1), and the processing proceeds to S1-9. On the other hand, in a case where the remaining life Trest_life_1 is equal to or longer than the symptom diagnosis threshold Vth_symptom_1, the symptom diagnosis unit 13 of the semiconductor integrated circuit 1_1 diagnoses that there is no symptom (NO in S1-5_1), and the processing proceeds to an activation sequence for the component B in S1-2_2 to S1-4_2.

The activation sequence for the component B in S1-2_2 to S1-4_2 is the same flow as that of the processing in S1-2 to S1-4 illustrated in FIG. 3, and thus the description thereof will be omitted. After the activation sequence for the component B in S1-2_2 to S1-4_2, the symptom diagnosis unit 13 (symptom diagnosis circuit 134) of the semiconductor integrated circuit 1_2 determines whether or not a symptom is present in the component B (S1-5_2).

In a case where a remaining life Trest_life_2 of the semiconductor integrated circuit 1_2 is shorter than a symptom diagnosis threshold Vth_symptom_2, the symptom diagnosis unit 13 of the semiconductor integrated circuit 1_2 diagnoses that a symptom is present in the component B (YES in S1-5_2), and the processing proceeds to S1-7. On the other hand, in a case where the remaining life Trest_life_2 is equal to or longer than the symptom diagnosis threshold Vth_symptom_2, the symptom diagnosis unit 13 of the semiconductor integrated circuit 1_2 diagnoses that there is no symptom (NO in S1-5_2), and the processing proceeds to S1-6.

The ECU 2A according to the seventh embodiment described above includes the plurality of semiconductor integrated circuits 1_1, 1_2 and the control circuit 8 that individually controls the plurality of semiconductor integrated circuits 1_1, 1_2. By connecting the current detection circuit 4A to each power supply line branched for the corresponding one of the semiconductor integrated circuits 1_1, 1_2, it is possible to perform symptom diagnosis individually for each of the semiconductor integrated circuits 1_1, 1_2. Moreover, the control circuit 8 can change the system control in accordance with the priority order for the semiconductor integrated circuits 1_1, 1_2 for any of which the presence of a symptom has been diagnosed.

Note that in the seventh embodiment, a method has been described in which symptom diagnosis is individually performed for each of the semiconductor integrated circuits by connecting each of the resistors for the corresponding one of the power supply lines for the semiconductor integrated circuits. However, a plurality of semiconductor integrated circuits may be collectively subjected to symptom diagnosis by connecting a resistor to a power supply line used in common for all the semiconductor integrated circuits.

In addition, in FIG. 18, the ECU 2A includes the two resistors 41_1, 41_2, the two semiconductor integrated circuits 1_1, 1_2, and the two drive circuits 5_1, 5_2. However, the ECU 2A may include three or more resistors, three or more semiconductor integrated circuits, and three or more drive circuits.

[Eighth Embodiment]

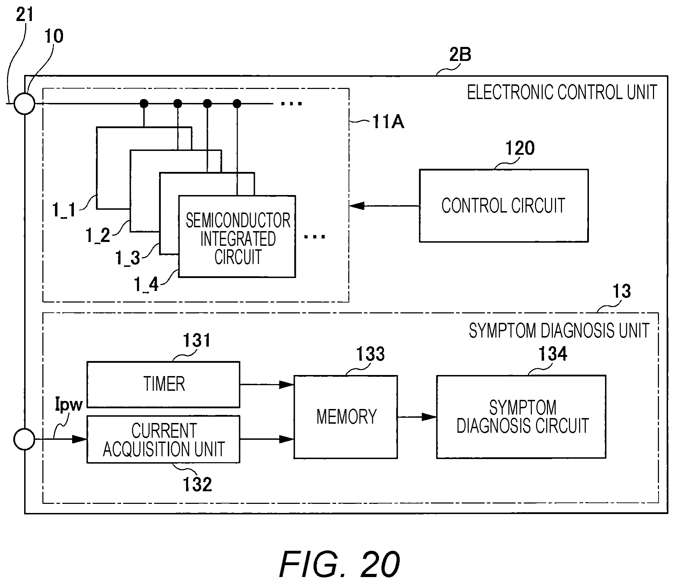

Next, a configuration example of an ECU according to an eighth embodiment of the invention will be described with reference to FIG. 20.

The ECU according to the eighth embodiment includes a symptom diagnosis unit that performs symptom diagnosis on each of a plurality of semiconductor integrated circuits, on the basis of consumption current of the plurality of semiconductor integrated circuits or a consumption current of the electronic control unit. Therefore, symptom diagnosis can be performed for each of the semiconductor integrated circuits. Note that differences from the semiconductor integrated circuit and the electronic control unit described in the first embodiment will be mainly described below.

<Configuration example of electronic control unit according to eighth embodiment>

FIG. 20 is a block diagram illustrating an internal configuration example of an electronic control unit 2B.

The electronic control unit 2B includes a power supply terminal 20, a circuit unit 11A, a control circuit 120, and the symptom diagnosis unit 13.

The circuit unit 11A includes semiconductor integrated circuits 1_1 to 1_4 as an example of the plurality of semiconductor integrated circuits.

The control circuit 120 controls the operation of each of the semiconductor integrated circuits included in the circuit unit 11A.

The symptom diagnosis unit 13 has a configuration similar to that of the symptom diagnosis unit 13 according to the first embodiment illustrated in FIG. 2. However, in the symptom diagnosis unit 13 according to the first embodiment, the presence or absence of a failure symptom in the main function circuit unit 11 is diagnosed on the basis of the time-series change in the value of the consumption current acquired from the main function circuits 111 to 114 of the main function circuit unit 11. On the other hand, the symptom diagnosis unit 13 according to the eighth embodiment is different in that the presence or absence of a failure symptom in the circuit unit 11A is diagnosed on the basis of a time-series change in the value of a consumption current acquired from the semiconductor integrated circuits 1 1 to 1_4 of the circuit unit 11A.

The current acquisition unit (current acquisition unit 132) acquires the consumption current of the plurality of semiconductor integrated circuits (semiconductor integrated circuits 1_1 to 1_4), or acquires the consumption current of the electronic control unit (electronic control unit 2B).

The timer (timer 131) measures an accumulated operation time in which a time during which the semiconductor integrated circuits (semiconductor integrated circuits 1_1 to 1_4) operate is accumulated.

The memory (memory 133) stores time-series data of the consumption current and the accumulated operation time acquired on a time-series basis in a diagnosis mode in which the semiconductor integrated circuits (semiconductor integrated circuits 1_1 to 1_4) operate at an activation ratio higher than the maximum activation ratio of the semiconductor integrated circuits (semiconductor integrated circuits 1_1 to 1_4) operating normally.

The symptom diagnosis circuit (symptom diagnosis circuit 134) diagnoses a failure symptom in the semiconductor integrated circuits (semiconductor integrated circuits 1_1 to 1_4) on the basis of the time-series data.

The ECU 2B according to the eighth embodiment described above can diagnose the failure symptom in the circuit unit 11A including the plurality of semiconductor integrated circuits 1 1 to 1_4 by the time-series change in the value of the

# EP 4 668 119 A1

consumption current acquired from the semiconductor integrated circuits 1 1 to 1_4 of the circuit unit 11A.

Note that it goes without saying that the invention is not limited to the embodiments described above, and various other application examples and modification examples can be adopted without departing from the gist of the invention in the claims.

For example, in each of the embodiments described above, the configurations of the ECU and the semiconductor integrated circuit have been described in detail and specifically, for describing the invention to facilitate easy understanding thereof, and the embodiments are not necessarily limited to those having all the described configurations. In addition, a part of the configurations of the embodiments described here can be replaced with a configuration of another embodiment, and a configuration of another embodiment can be added to a configuration of a certain embodiment. Moreover, another configuration can be added to or removed from a part of the configurations of the embodiments, or a part of the configurations of the embodiments can be replaced with another configuration.

Further, control lines and information lines considered to be necessary for the description are illustrated, and all the control lines and the information lines in the product may not necessarily be illustrated. In practice, it may be considered that almost all the configurations are connected to each other.

Reference Signs List

| | |
|---|---|
| 1A | semiconductor integrated circuit |
| 2 | ECU |
| 3 | power supply circuit |
| 4 | current detection circuit |
| 5 | drive circuit |
| 8 | control circuit |
| 10 | power supply terminal |
| 11 | main function circuit unit |
| 12 | main function control circuit |
| 13 | symptom diagnosis unit |
| 21 | power supply line |
| 41 | resistor |
| 42 | detection circuit |
| 111 | main function circuit |
| 131 | timer |
| 132 | current acquisition unit |
| 133 | memory |
| 134 | symptom diagnosis circuit |

## Claims

1. A semiconductor integrated circuit, comprising:

   a power supply terminal to which power is supplied from an external power supply;
   a circuit unit including a plurality of circuits, the plurality of circuits being configured to operate at a predetermined activation ratio, with power supplied from the power supply terminal;
   a current acquisition unit configured to acquire, from the power supply terminal, a consumption current of the power consumed in the circuit unit;
   a timer configured to measure an accumulated operation time in which a time during which the circuit unit operates is accumulated; and
   a symptom diagnosis circuit configured to diagnose a failure symptom in the circuit unit, based on time-series data of the consumption current and the accumulated operation time, acquired on a time-series basis in a diagnosis mode in which the circuit unit operates at an activation ratio higher than a maximum activation ratio of the circuit unit operating normally.

2. The semiconductor integrated circuit according to claim 1, further comprising:
   a memory configured to store the time-series data of the consumption current and the accumulated operation time acquired in the diagnosis mode.

3. The semiconductor integrated circuit according to claim 2, wherein the symptom diagnosis circuit is configured to calculate a time until the consumption current acquired in the diagnosis mode reaches a symptom diagnosis threshold, based on the time-series data of the consumption current and the accumulated operation time, and is configured to predict a failure occurrence timing of the circuit unit.

4. The semiconductor integrated circuit according to claim 3, wherein the symptom diagnosis circuit is configured to change the symptom diagnosis threshold in accordance with a slope of the consumption current with respect to the accumulated operation time of the time-series data.

5. The semiconductor integrated circuit according to claim 3, wherein

   the memory has, as an initial value, information on the consumption current acquired in the diagnosis mode at a time of a manufacturing process or shipment, and
   the symptom diagnosis threshold calculated based on the initial value is set in the memory.

6. The semiconductor integrated circuit according to claim 3, further comprising:

   a temperature information acquisition unit configured to acquire temperature information from a temperature detection unit configured to detect a temperature inside the semiconductor integrated circuit or around the semiconductor integrated circuit,
   wherein the symptom diagnosis circuit is configured to predict the failure occurrence timing of the circuit unit by using the symptom diagnosis threshold or the consumption current corrected based on the temperature information.

7. The semiconductor integrated circuit according to claim 3, further comprising:

   a voltage information acquisition unit configured to acquire voltage information from a voltage detection unit configured to detect a power supply voltage of the power supply terminal,
   wherein the symptom diagnosis circuit is configured to predict the failure occurrence timing of the circuit unit by using the symptom diagnosis threshold or the consumption current corrected based on the voltage information.

8. The semiconductor integrated circuit according to claim 3, wherein diagnosis of a failure symptom in the diagnosis mode is performed at a time of activation of or at a time of termination of the semiconductor integrated circuit.

9. The semiconductor integrated circuit according to claim 8, wherein after the symptom diagnosis circuit has diagnosed that the failure symptom is present, at least one of control in which a function of the circuit unit is limited, control in which torque of a vehicle is limited, control in which the circuit unit is operated except for a portion where the failure symptom has been detected, or control in which a maximum operation of a system including the semiconductor integrated circuit is not performed is performed.

10. The semiconductor integrated circuit according to claim 3, wherein

    the diagnosis mode includes a plurality of the diagnosis modes in which an operation state of the circuit unit varies, and
    the symptom diagnosis circuit is configured to perform symptom diagnosis, based on the time-series data acquired for each of the plurality of the diagnosis modes from the circuit unit operating in the plurality of the diagnosis modes.

11. The semiconductor integrated circuit according to claim 10, wherein, in at least one of the plurality of the diagnosis modes, the circuit unit is configured to operate with a consumption current smaller than the consumption current consumed in the circuit unit operating normally.

12. The semiconductor integrated circuit according to claim 6, further comprising:

    an abnormality diagnosis unit configured to diagnose an abnormality in some of the plurality of circuits, based on information acquired from the circuit unit,
    wherein after the symptom diagnosis circuit has diagnosed that a failure symptom is present, the abnormality diagnosis unit is configured to diagnose abnormality for some of the plurality of circuits in which the abnormality has been detected.

13. The semiconductor integrated circuit according to claim 3, wherein after the symptom diagnosis circuit has diagnosed that the failure symptom is present, control on a semiconductor integrated circuit or a system including a semiconductor integrated circuit is changed.

14. An electronic control unit, comprising:

a semiconductor integrated circuit in which a plurality of circuits are integrated,
wherein
the semiconductor integrated circuit includes:

a power supply terminal to which power is supplied from an external power supply;
a circuit unit including a plurality of circuits, the plurality of circuits being configured to operate at a predetermined activation ratio, with power supplied from the power supply terminal;
an abnormality diagnosis unit configured to diagnose an abnormality in some of the plurality of circuits, based on information acquired from the circuit unit;
a current acquisition unit configured to acquire, from the power supply terminal, a consumption current of the power consumed in the circuit unit;
a timer configured to measure an accumulated operation time in which a time during which the circuit unit operates is accumulated;
a memory configured to store time-series data of the consumption current and the accumulated operation time acquired in a diagnosis mode in which the circuit unit operates at an activation ratio higher than a maximum activation ratio of the circuit unit operating normally; and
a symptom diagnosis circuit configured to diagnose a failure symptom in the circuit unit, based on time-series data of the consumption current and the accumulated operation time, acquired on a time-series basis in the diagnosis mode, and
an abnormality is detected for each semiconductor integrated circuit including some of the plurality of circuits for which the abnormality has been diagnosed.

15. An electronic control unit, comprising:

a plurality of semiconductor integrated circuits,
the electronic control unit, further comprising:

a current acquisition unit configured to acquire a consumption current of the plurality of semiconductor integrated circuits, or acquire a consumption current of the electronic control unit;
a timer configured to measure an accumulated operation time in which a time during which each of the plurality of semiconductor integrated circuits operates is accumulated;
a memory configured to store time-series data of the consumption current and the accumulated operation time acquired in a diagnosis mode in which a circuit unit operates at an activation ratio higher than a maximum activation ratio of the circuit unit operating normally; and
a symptom diagnosis circuit configured to diagnose a failure symptom in the semiconductor integrated circuit, based on the time-series data.

# FIG. 1

FIG. 2

*FIG. 3*

S1-1

TURN-ON OF POWER (IGNITION ON)

S1-2

START TO OPERATE TIMER,
AND PERFORM DATA SETTING

S1-3

PERFORM SELF-DIAGNOSIS ON HARDWARE

S1-4

SYMPTOM DIAGNOSIS

S1-5

IS SYMPTOM PRESENT? —— NO

YES

S1-7

NOTIFY USER

S1-6

PERFORM NORMAL OPERATION

S1-8

NO —— HAS IGNITION BEEN
TURNED OFF?

YES

S1-9

PERFORM SHUTDOWN PROCESSING
(STOP OPERATION OF TIMER, ETC.)

S1-10

STOP OF ECU

```
                    ┌─────────────┐
                    │    S1-3     │
                    └──────┬──────┘
                           │                      S1-41
                           ▼
        ┌──────────────────────────────────────────────┐
        │  PERFORM CONTROL TO BE HIGHER CIRCUIT ACTIVATION RATIO  │
        └──────────────────────┬───────────────────────┘
                               │                  S1-42
                               ▼
        ┌──────────────────────────────────────────────┐
        │      ACQUIRE VOLTAGE HAVING POWER SUPPLY CURRENT      │
        │    INFORMATION AND ACCUMULATED OPERATION TIME        │
        └──────────────────────┬───────────────────────┘
                               │                  S1-43
                               ▼
        ┌──────────────────────────────────────────────┐
        │       PERFORM AD CONVERSION OF VOLTAGE HAVING       │
        │          POWER SUPPLY CURRENT INFORMATION          │
        └──────────────────────┬───────────────────────┘
                               │                  S1-44
                               ▼
        ┌──────────────────────────────────────────────┐
        │           STORE POWER SUPPLY CURRENT DATA          │
        │      AND ACCUMULATED OPERATION TIME DATA        │
        │      IN MEMORY IN ASSOCIATION WITH EACH OTHER     │
        └──────────────────────┬───────────────────────┘
                               │                  S1-45
                               ▼
        ┌──────────────────────────────────────────────┐
        │    RETURN TO CIRCUIT ACTIVATION RATIO IDENTICAL TO   │
        │  CIRCUIT ACTIVATION RATIO BEFORE SYMPTOM DIAGNOSIS │
        └──────────────────────┬───────────────────────┘
                               │                  S1-46
                               ▼
        ┌──────────────────────────────────────────────┐
        │              PERFORM SYMPTOM DIAGNOSIS             │
        └──────────────────────┬───────────────────────┘
                               │
                               ▼
                    ┌─────────────┐
                    │    S1-5     │
                    └─────────────┘
```

FIG. 4

## FIG. 5

## FIG. 6

| SYMPTOM DIAGNOSIS TIME POINT | DATA COLUMN OF ACCUMULATED OPERATION TIME (Dt_col) | DATA COLUMN OF POWER SUPPLY CURRENT (Di_col) |
|---|---|---|
| T1 | 0 | 50 |
| T2 | 20 | 50 |
| . . . | . . . | . . . |
| T3 | 80051 | 50 |
| T4 | 80071 | 50 |
| T5 | 80091 | 53 |
| T6 | 80111 | 60 |
| T7 | 80131 | 70 |
| T8 | 80151 | 75 |
| T9 | 80171 | 95 |

# FIG. 7

# FIG. 8

POWER SUPPLY
CURRENT
Ipw

FAILURE CURRENT
(Ibreak)

INITIAL VALUE (Iini)

T1

T9
(Tcur)

T10
(Tbreak)

ACCUMULATED OPERATION TIME Tacc

REMAINING LIFE
(Trest_life)

# FIG. 9

51 CPU

52 ROM

53 RAM

54

50

55 NONVOLATILE
STORAGE

56 NETWORK
INTERFACE

## FIG. 10

21 10

1B

SEMICONDUCTOR INTEGRATED CIRCUIT

11

12

MAIN FUNCTION
CONTROL CIRCUIT

111
112
113
114

MAIN
FUNCTION
CIRCUIT

13B

SYMPTOM DIAGNOSIS UNIT

131

TIMER

Ipw

133

134

132

CURRENT
ACQUISITION UNIT

MEMORY

SYMPTOM
DIAGNOSIS CIRCUIT

135

MEMORY

*FIG. 11*

S2-1
( SHIPMENT TEST START )

S2-2
IS PRODUCT NON-DEFECTIVE PRODUCT?

NO ←

YES

S2-3
ACQUIRE INITIAL VALUE OF POWER SUPPLY CURRENT

S2-4
IS INITIAL VALUE OF POWER SUPPLY CURRENT NORMAL?

NO ←

YES

S2-5
CALCULATE FAILURE CURRENT

S2-7
WRITE FAILURE CURRENT IN MEMORY

S2-6
( DISCARD )

S2-8
( SHIPMENT )

# FIG. 12

SEMICONDUCTOR INTEGRATED CIRCUIT 1C

MAIN FUNCTION CONTROL CIRCUIT 12

MAIN FUNCTION CIRCUIT

111 112 113 114

SYMPTOM DIAGNOSIS UNIT 13C

TIMER 131

CURRENT ACQUISITION UNIT 132

MEMORY 133

SYMPTOM DIAGNOSIS CIRCUIT 134

MEMORY 138

VOLTAGE ACQUISITION UNIT 136

CORRECTION CIRCUIT 139

TEMPERATURE ACQUISITION UNIT 137

Ipw   Vpw   Ttemp

*FIG. 13*

S1-1
TURN-ON OF POWER (IGNITION ON)

S1-2
START TO OPERATE TIMER, AND PERFORM DATA SETTING

S1-3
PERFORM SELF-DIAGNOSIS ON HARDWARE

S1-4
SYMPTOM DIAGNOSIS

S1-5
IS SYMPTOM PRESENT?

YES

NO

S1-7
NOTIFY USER

S1-11
IS REMAINING LIFE UNTIL FAILURE EQUAL TO OR MORE THAN THRESHOLD?

NO

YES

S1-12
PERFORM CONDITIONAL OPERATION

S1-8A
HAS IGNITION BEEN TURNED OFF?

YES

NO

S1-6
PERFORM NORMAL OPERATION

S1-8
HAS IGNITION BEEN TURNED OFF?

NO

YES

S1-9
PERFORM SHUTDOWN PROCESSING (STOP OPERATION OF TIMER, ETC.)

S1-10
STOP OF ECU

*FIG. 14*

S1-1
TURN-ON OF POWER (IGNITION ON)

S1-2
START TO OPERATE TIMER,
AND PERFORM DATA SETTING

S1-3
PERFORM SELF-DIAGNOSIS ON HARDWARE

S1-4
SYMPTOM DIAGNOSIS

S1-5
IS SYMPTOM PRESENT?
YES → NO

S1-7
NOTIFY USER

S1-13
PERFORM INDIVIDUAL DIAGNOSIS

S1-14
IS ABNORMALITY PRESENT IN AT LEAST ONE OF MAIN FUNCTION CIRCUITS?
NO
YES

S1-6
PERFORM NORMAL OPERATION

S1-12
PERFORM CONDITIONAL OPERATION

S1-8
HAS IGNITION BEEN TURNED OFF?
NO
YES

S1-8A
HAS IGNITION BEEN TURNED OFF?
YES
NO

S1-9
PERFORM SHUTDOWN PROCESSING (STOP OPERATION OF TIMER, ETC.)

S1-10
STOP OF ECU

S1-3

S1-41
PERFORM CONTROL TO BE HIGHER CIRCUIT ACTIVATION RATIO

S1-42A
ACQUIRE VOLTAGE (POWER SUPPLY CURRENT INFORMATION) AND ACCUMULATED OPERATION TIME

S1-43A
PERFORM AD CONVERSION OF VOLTAGE (POWER SUPPLY CURRENT INFORMATION)

S1-44A
STORE CONVERTED DATA IN MEMORY

S1-47
PERFORM CONTROL SUCH THAT CIRCUIT ACTIVATION RATIO BECOMES RATIO AT WHICH POWER SUPPLY CURRENT IS MINIMIZED

S1-42B
ACQUIRE VOLTAGE (POWER SUPPLY CURRENT INFORMATION) AND ACCUMULATED OPERATION TIME

S1-43B
PERFORM AD CONVERSION OF VOLTAGE (POWER SUPPLY CURRENT INFORMATION)

S1-44B
STORE CONVERTED DATA IN MEMORY

S1-46A
CALCULATE REMAINING LIFE BASED ON RESULT OF DIAGNOSIS A

S1-46B
CALCULATE REMAINING LIFE BASED ON RESULT OF DIAGNOSIS B

S1-51
IS SYMPTOM PRESENT?

YES

NO

S1-6

S1-7

*FIG. 15*

# FIG. 16

## FIG. 17

S1-1
TURN-ON OF POWER (IGNITION ON)

S1-2
START TO OPERATE TIMER,
AND PERFORM DATA SETTING

S1-3
PERFORM SELF-DIAGNOSIS ON HARDWARE

S1-4
SYMPTOM DIAGNOSIS

S1-5
IS SYMPTOM PRESENT?
YES → S1-7
NO ↓

S1-7
NOTIFY USER

S1-13
PERFORM INDIVIDUAL DIAGNOSIS

S1-14
IS THERE FAILURE IN MAIN FUNCTION?
NO →
YES ↓

S1-6
PERFORM NORMAL OPERATION

S1-12
PERFORM CONDITIONAL OPERATION

S1-8
HAS IGNITION BEEN TURNED OFF?
NO →
YES ↓

S1-8A
HAS IGNITION BEEN TURNED OFF?
YES →
NO

S1-13A
PERFORM INDIVIDUAL DIAGNOSIS

S1-15
IS THERE ABNORMALITY DETECTION?
NO
YES

S1-9
PERFORM SHUTDOWN PROCESSING
(STOP OPERATION OF TIMER, ETC.)

S1-10
STOP OF ECU

# FIG. 18

*FIG. 19*

**ELECTRONIC CONTROL UNIT**

2B

21
10

11A

120

CONTROL CIRCUIT

1_1
1_2
1_3
1_4

SEMICONDUCTOR INTEGRATED CIRCUIT ...

13

**SYMPTOM DIAGNOSIS UNIT**

131

TIMER

Ipw

132

CURRENT ACQUISITION UNIT

133

MEMORY

134

SYMPTOM DIAGNOSIS CIRCUIT

## FIG. 20

## INTERNATIONAL SEARCH REPORT

| International application No. |
|---|
| **PCT/JP2023/005354** |

**A.     CLASSIFICATION OF SUBJECT MATTER**

*G06F 11/22*(2006.01)i; *G01R 31/3187*(2006.01)i

FI:     G06F11/22 673G; G01R31/3187

According to International Patent Classification (IPC) or to both national classification and IPC

**B.     FIELDS SEARCHED**

Minimum documentation searched (classification system followed by classification symbols)

G06F11/22; G01R31/3187

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.     DOCUMENTS CONSIDERED TO BE RELEVANT**

| Category* | Citation of document, with indication, where appropriate, of the relevant passages | Relevant to claim No. |
|---|---|---|
| A | JP 2021-120234 A (HITACHI ASTEMO, LTD.) 19 August 2021 (2021-08-19) paragraphs [0014]-[0042] | 1-15 |
| A | JP 09-123894 A (DENSO CORPORATION) 13 May 1997 (1997-05-13) paragraphs [0022]-[0024], [0028] | 1-15 |
| A | JP 07-218595 A (HITACHI, LTD.) 18 August 1995 (1995-08-18) paragraphs [0036]-[0039] | 1-15 |
| A | WO 2020/110446 A1 (SUMITOMO ELECTRIC INDUSTRIES, LTD.) 04 June 2020 (2020-06-04) paragraphs [0058], [0063] | 1-15 |
| A | JP 2002-107414 A (ADVANTEST CORPORATION) 10 April 2002 (2002-04-10) paragraphs [0028]-[0029] | 1-15 |

☐ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 April 2023** | **18 April 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

EP 4 668 119 A1

## INTERNATIONAL SEARCH REPORT
### Information on patent family members

International application No.

**PCT/JP2023/005354**

| Patent document cited in search report | | | Publication date (day/month/year) | Patent family member(s) | Publication date (day/month/year) |
|---|---|---|---|---|---|
| JP | 2021-120234 | A | 19 August 2021 | WO 2019/207905 A1 paragraphs [0014]-[0042] | |
| JP | 09-123894 | A | 13 May 1997 | US 5897596 A claim 3, lines 25-53, column 4, line 38 to column 5, line 30 DE 19633952 A1 | |
| JP | 07-218595 | A | 18 August 1995 | (Family: none) | |
| WO | 2020/110446 | A1 | 04 June 2020 | US 2021/0327165 A1 paragraphs [0065], [0070] CN 112912282 A | |
| JP | 2002-107414 | A | 10 April 2002 | (Family: none) | |

Form PCT/ISA/210 (patent family annex) (January 2015)

**EP 4 668 119 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002322939 A